(19) **Europäisches Patentamt / European Patent Office / Office européen des brevets**

(11) **EP 4 769 562 A1**

(12) **EUROPEAN PATENT APPLICATION**
published in accordance with Art. 153(4) EPC

(43) Date of publication:
**01.07.2026 Bulletin 2026/27**

(21) Application number: **24907807.2**

(22) Date of filing: **18.11.2024**

(51) International Patent Classification (IPC):
$H01M\ 4/505^{(2010.01)}$  $H01M\ 4/525^{(2010.01)}$
$H01M\ 4/36^{(2006.01)}$  $H01M\ 4/70^{(2006.01)}$
$H01M\ 10/04^{(2006.01)}$  $H01M\ 10/052^{(2010.01)}$
$C30B\ 29/22^{(2006.01)}$  $H01M\ 4/02^{(2006.01)}$

(52) Cooperative Patent Classification (CPC):
C30B 29/22; H01M 4/02; H01M 4/36; H01M 4/505;
H01M 4/525; H01M 4/70; H01M 10/04;
H01M 10/052; Y02E 60/10

(86) International application number:
**PCT/KR2024/018157**

(87) International publication number:
**WO 2025/135522 (26.06.2025 Gazette 2025/26)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **22.12.2023 KR 20230190076**

(71) Applicant: **LG Energy Solution, Ltd.**
**Seoul 07335 (KR)**

(72) Inventors:
• **KIM, Na Yeon**
**Daejeon 34122 (KR)**

• **HAN, Seung Mi**
**Daejeon 34122 (KR)**
• **CHOI, Ji Hwan**
**Daejeon 34122 (KR)**
• **KIM, Do Yeon**
**Daejeon 34122 (KR)**
• **JEONG, Gang Hyeon**
**Daejeon 34122 (KR)**
• **KIM, Dong Uk**
**Daejeon 34122 (KR)**

(74) Representative: **Hoffmann Eitle**
**Patent- und Rechtsanwälte PartmbB**
**Arabellastraße 30**
**81925 München (DE)**

(54) **CATHODE MATERIAL AND LITHIUM SECONDARY BATTERY COMPRISING SAME**

(57) The present invention relates to a cathode material comprising: a first cathode active material comprising a lithium manganese-based oxide having a spinel structure; and a second cathode active material having a layered structure and comprising a lithium nickel-based oxide including nickel (Ni), cobalt (Co), manganese (Mn), and aluminum (Al), wherein the lithium manganese-based oxide and the lithium nickel-based oxide are single-particle particles

**EP 4 769 562 A1**

[FIG. 5]

**Description**

**TECHNICAL FIELD**

**Cross-reference to Related Applications**

This application claims the benefit of priority from Korean Patent Application No. 10-2023-0190076, filed on December 22, 2023, in the Korean Intellectual Property Office, the contents of which are incorporated herein by reference.

**Technical Field**

The present invention relates to a positive electrode material and a lithium secondary battery comprising the same, and more particularly, to a positive electrode material having excellent thermal stability and capacity characteristics while reducing a manganese elution amount at high temperatures, and a lithium secondary battery comprising the positive electrode active material.

**BACKGROUND ART**

Recently, the development of large-volume, large can-type batteries is in progress to further increase the capacity of batteries for electric vehicles. In the case of the conventionally used small cylindrical batteries, that is, cylindrical batteries with form factors of 1865 or 2170, resistance or heat generation did not have a serious impact on battery performance because the capacity was small. However, if the specifications of the conventional small cylindrical batteries are applied to large batteries as they are, serious problems with battery safety may arise.

As the size of the battery increases, the amount of heat and gas generated inside the battery also increases, and the heat and gas may cause the temperature and pressure inside the battery to rise, which may cause the battery to catch fire or explode. To prevent the defects, the heat and gas inside the battery are required to be properly discharged to the outside, and for this, the cross-sectional area of the battery, which serves as a passage for discharging heat outside the battery, is required to increase in proportion to the increase in volume. However, since the increase in a cross-sectional area is usually not enough to increase the volume, as the battery becomes larger, the amount of heat generated inside the battery increases, which induces other problems including the increase of the risk of explosion, and reduction of output. In addition, if rapid charging is performed at high voltage, a problem may occur in which the battery catches fire due to the generation of a lot of heat around electrode tabs in a short period of time.

Meanwhile, lithium manganese oxides with a spinel structure such as $LiMn_2O_4$ have the advantages of excellent thermal stability and low price, but have problems such as small capacity, structural deformation (Jahn-Teller distortion) due to $Mn^{3+}$ during charging and discharging, and Mn elution due to HF formed by a reaction with an electrolyte at high temperatures, which rapidly deteriorates the performance of a lithium secondary battery.

Therefore, there is a need to develop a lithium secondary battery with excellent thermal stability and capacity characteristics, low manganese elution at high temperatures, and excellent life characteristics.

**DISCLOSURE OF THE INVENTION**

**TECHNICAL PROBLEM**

The present invention is to solve the above problems and provides a positive electrode material that includes a lithium manganese-based oxide having a spinel structure while reducing a manganese elution amount at high temperatures. In addition, the present invention is intended to provide a lithium secondary battery having excellent thermal stability, life characteristics at high temperatures, and capacity characteristics, by including the positive electrode material according to the present invention.

**TECHNICAL SOLUTION**

[1] The present invention provides a positive electrode material comprising: a first positive electrode active material comprising a lithium manganese-based oxide having a spinel structure; and a second positive electrode active material comprising a lithium nickel-based oxide having a layered structure and comprising nickel (Ni), cobalt (Co), manganese (Mn), and aluminum (Al), wherein the lithium manganese-based oxide and the lithium nickel-based oxide are particles in a single particle form.

[2] The present invention provides the positive electrode material according to [1], wherein the lithium nickel-based oxide comprises nickel in 90 mol% or more among all metals excluding lithium.

[3] The present invention provides the positive electrode material according to [1] or [2], wherein a weight ratio of the first positive electrode active material and the second positive electrode active material is 75:25 to 50:50.

[4] The present invention provides the positive electrode material according to at least one of [1] to [3], wherein a ratio of an average particle diameter ($D_{50}$) of the first positive electrode active material and the second positive electrode active material is 5:1 to 1.5:1.

[5] The present invention provides the positive electrode material according to at least one of [1] to [4], wherein an average particle diameter ($D_{50}$) of the first positive electrode active material is 5 $\mu$m to 20 $\mu$m.

[6] The present invention provides the positive electrode material according to at least one of [1] to [5], wherein an average particle diameter ($D_{50}$) of the second positive electrode active material is 1 $\mu$m to 10 $\mu$m.

[7] The present invention provides the positive electrode material according to at least one of [1] to [6], wherein the lithium manganese-based oxide has a composition represented by [Formula 1] below.

[Formula 1] $\quad$ $Li_{1+a1}Mn_{2-x1}M^1_{x1}O_{4-y1}A_{y1}$

In Formula 1, $M^1$ is one or more doping elements selected from the group consisting of Al, Li, Mg, Zn, B, W, Ni, Co, Fe, Cr, V, Ru, Cu, Cd, Ag, Y, Sc, Ga, In, As, Sb, Pt, Au, and Si, A is one or more elements selected from the group consisting of F, Cl, Br, I, At, and S, $0\leq a1\leq 0.4$, $0<x1\leq 0.5$, and $0\leq y1\leq 0.1$.

[8] The present invention provides the positive electrode material according to at least one of [1] to [7], wherein the lithium manganese-based oxide comprises $M^1$ in 0.5 wt% to 3 wt% based on the total weight of the lithium manganese-based oxide.

[9] The present invention provides the positive electrode material according to at least one of [1] to [8], wherein a first coating layer positioned on the surface of the lithium manganese-based oxide is comprised, and the first coating layer comprises one or more elements selected from the group consisting of Al, Ti, W, F, P, Mg, Ni, Co, Fe, Cr, V, Cu, Ca, Zn, Zr, Nb, Mo, Sr, Sb, Bi, Si, S and B.

[10] The present invention provides the positive electrode material according to [9], wherein the first coating layer is comprised in 0.05 wt% to 0.3 wt% based on the total weight of the first positive electrode active material.

[11] The present invention provides the positive electrode material according to at least one of [1] to [10], wherein the lithium nickel-based oxide has a composition represented by [Formula 2] below.

[Formula 2] $\quad$ $Li_{a2}[Ni_{x2}Co_{y2}Mn_{z2}Al_{w2}M^2_{v2}]O_2$

In Formula 2, $M^2$ is one or more doping elements selected from the group consisting of W, Cu, Fe, V, Cr, Ti, Zr, Zn, In, Ta, Y, La, Sr, Ga, Sc, Gd, Sm, Ca, Ce, Nb, Mg, B, and Mo, $0.8\leq a2\leq 1.2$, $0.9\leq x2<1$, $0<y2\leq 0.2$, $0<z2\leq 0.2$, $0<w2\leq 0.2$, and $0\leq v2\leq 0.1$.

[12] The present invention provides the positive electrode material according to at least one of [1] to [11], wherein a second coating layer positioned on the surface of the lithium nickel-based oxide is comprised, and the second coating layer comprises one or more elements selected from the group consisting of Ti, W, B, F, P, Mg, Ni, Fe, Cr, V, Cu, Ca, Zn, Zr, Nb, Mo, Sr, Sb, Bi, Si, S, Co and Al.

[13] The present invention provides the positive electrode material according to [12], wherein the second coating layer is comprised in 0.01 wt% to 5 wt% based on the total weight of the second positive electrode active material.

[14] The present invention provides a lithium secondary battery comprising: an electrode assembly comprising a positive electrode comprising the positive electrode material according to any one of [1] to [13], a negative electrode, and a separator interposed between the positive electrode and the negative electrode; an electrolyte; and a battery case accommodating the electrode assembly and the electrolyte.

[15] The present invention provides the lithium secondary battery according to [14], wherein the battery case is a cylindrical battery case.

[16] The present invention provides the lithium secondary battery according to [14] or [15], wherein the lithium secondary battery has a ratio (form factor ratio) of a diameter (T) to a height (H) of 0.4 or more.

[17] The present invention provides the lithium secondary battery according to at least one of [14] to [16], wherein the lithium secondary battery comprises a non-coated part on which an active material layer is not formed on at least a portion of the positive electrode and the negative electrode, and the non-coated part of the positive electrode and the non-coated part of the negative electrode are defined as electrode tabs.

**ADVANTAGEOUS EFFECTS**

According to the present invention, a manganese elution amount at high temperatures may be significantly reduced by using a positive electrode material in which a lithium manganese-based oxide having a spinel structure and a lithium nickel-based oxide containing nickel, cobalt, manganese and aluminum are mixed, and both the lithium manganese-based oxide and the lithium nickel-based oxide are particles in a single particle form. Accordingly, the positive electrode material according to the present invention may have excellent high-temperature storage characteristics and high-temperature cycle characteristics compared to the conventional material.

In addition, the positive electrode material according to the present invention may improve the thermal stability of a lithium secondary battery by including a lithium manganese-based oxide having a spinel structure, and may realize high energy density and high-capacity characteristics by including a lithium nickel-based oxide having excellent capacity characteristics.

## BRIED DESCRIPTION OF DRAWINGS

FIG. 1 is a diagram showing a laminate state before winding of an electrode assembly according to the present invention.

FIG. 2 is a cross-sectional view showing the structure of an electrode of an electrode assembly according to an embodiment of the present invention.

FIG. 3 is a diagram for explaining the structure of an electrode assembly according to an embodiment of the present invention.

FIG. 4 is a cross-sectional view showing the structure of a lithium secondary battery according to an embodiment of the present invention.

FIG. 5 is a cross-sectional view showing the structure of a lithium secondary battery according to another embodiment of the present invention.

FIG. 6 is a diagram for explaining a battery pack according to the present invention.

FIG. 7 is a surface image of a lithium manganese-based oxide prepared in Preparation Example 1 of the present invention at a magnification of 3,000 times, acquired using a scanning electron microscope.

FIG. 8 is a surface image of a lithium nickel-based oxide prepared in Preparation Example 3 of the present invention at a magnification of 5,000 times, acquired using a scanning electron microscope.

FIG. 9 is a surface image of a lithium nickel-based oxide prepared in Preparation Example 4 of the present invention at a magnification of 5,000 times, acquired using a scanning electron microscope.

## BEST MODE FOR CARRYING OUT THE INVENTION

Hereinafter, the present invention will be explained in more detail.

Words or terms used in the present description and claims shall not be interpreted as the meaning defined in commonly used dictionaries. The words or terms should be interpreted as having a meaning that is consistent with the technical idea of the invention, based on the principle that an inventor may properly define the meaning of the words or terms to best explain the invention.

Terms used in the present specification are used only to explain embodiments and are not intended to limit the present invention. Singular expression includes plural expression, unless otherwise clearly indicated.

In the present specification, the terms "comprise," "include," or "have" are intended to specify the presence of a feature, number, step, component, or combination thereof, but should be understood not to preclude the possibility of the presence or addition of one or more other features, numbers, steps, components, or combinations thereof.

In the present invention, "particle in a single particle form" means a particle composed of 30 or fewer nodules, and is a concept including a single particle and a pseudo-single particle. "Single particle" means a particle composed of one single nodule, and "pseudo-single particle" means a particle that is a composite formed of 30 or fewer nodules.

In the present invention, "nodule" is a particle unit body that constitutes a single particle and a pseudo-single particle, and may be a single crystal without a crystalline grain boundary, or a polycrystal that does not have a grain boundary in appearance if observed with a scanning electron microscope (SEM) at a magnification of 5000 to 20000 times.

In the present invention, "secondary particle" means a particle formed by aggregation of tens to hundreds of multiple primary particles. More specifically, the secondary particle may be an aggregate of 40 or more primary particles.

In the present invention, the expression "particle" includes any one or all of a single particle, a pseudo-single particle, a primary particle, a nodule, and a secondary particle.

In the present invention, "average particle diameter D50" means a particle size at 50% of the volume cumulative particle size distribution of positive electrode active material powder, and may be measured using a laser diffraction method. For example, after dispersing the positive electrode active material powder in a dispersion medium, the dispersion is introduced into a commercially available laser diffraction particle size measuring device (for example, Microtrac MT 3000), ultrasonic waves of about 28 kHz at an output of 60 W is irradiated, a volume cumulative particle size distribution graph is obtained, and then the particle size corresponding to 50% of the volume cumulative amount is obtained, thereby measuring the particle size.

The inventors of the present invention have conducted repeated research to develop a positive electrode material having excellent thermal stability and excellent high-temperature storage and cycle characteristics, and as a result, have found that if a lithium manganese-based oxide having a single particle form and a spinel structure, and a lithium nickel-based oxide having a single particle form are used together, a manganese elution amount at high temperatures is significantly reduced, so that high-temperature storage and high-temperature cycle characteristics are excellent, while thermal stability and capacity characteristics may be improved, thereby completing the present invention.

Hereinafter, the present invention will be described in detail.

The positive electrode material, and/or lithium secondary battery according to the present invention include at least one or more of the configurations disclosed below, and may include any combination of technically possible configurations among the configurations below.

**Positive Electrode Material**

The positive electrode material according to the present invention comprises: a first positive electrode active material comprising a lithium manganese-based oxide having a spinel structure; and a second positive electrode active material comprising a lithium nickel-based oxide having a layered structure and containing nickel (Ni), cobalt (Co), manganese (Mn), and aluminum (Al), wherein the lithium manganese-based oxide and the lithium nickel-based oxide are particles in a single particle form.

In general, if a lithium manganese-based oxide having a spinel structure is used as a positive electrode material for a lithium secondary battery, there are advantages in that the thermal stability of the lithium secondary battery using the lithium manganese-based oxide may be excellent and the cost may be reduced, but if the lithium manganese-based oxide is used alone, there are disadvantages in that there is a limitation in terms of the capacity characteristics of the lithium secondary battery.

In addition, in the case of the lithium manganese-based oxide having a spinel structure, if the oxidation number of manganese becomes +3.5 or lower while repeating charging and discharging, a structural deformation (Jahn-Teller distortion) phenomenon may occur due to $Mn^{3+}$ having a high-spin $d^4$ electron configuration. Accordingly, the structure of the lithium manganese-based oxide having the spinel structure may become unstable. In particular, at a high temperature of 50° C or higher, the $Mn^{3+}$ may form $Mn^{2+}$ ions through a disproportionation reaction according to Reaction A below, and there is a problem that the $Mn^{2+}$ ions are eluted into an electrolyte. In addition, if charging and discharging are repeated in a high-voltage environment, a $LiPF_6$ additive in the electrolyte decomposes to produce hydrofluoric acid (HF), and as the manganese elution is accelerated by the HF, the deterioration of the positive electrode material is aggravated, resulting in further deterioration of the performance of the lithium secondary battery.

The inventors of the present invention have conducted repeated research to solve the above problems, and as a result, have found that by mixing a lithium manganese-based oxide having a spinel structure and a lithium nickel-cobalt-manganese-aluminum oxide, and using particles in a single particle form of the lithium manganese-based oxide and the lithium nickel-cobalt-manganese-aluminum oxide, the manganese elution amount at high temperatures is significantly reduced, thereby improving the life characteristics and capacity characteristics. On the other hand, according to the research of the inventors of the present invention, even if the lithium manganese-based oxide and the lithium nickel-cobalt-manganese-aluminum oxide are mixed and used, if one of the two has a particle form of a secondary particle, or if the lithium nickel-based oxide is not a quaternary oxide containing nickel, cobalt, manganese, and aluminum, the effect of reducing the high-temperature manganese elution is insignificant.

Meanwhile, in the present invention, the weight ratio of the first positive electrode active material and the second positive electrode active material may be 75:25 to 50:50, preferably 70:30 to 52:48, more preferably 65:35 to 55:45, and even more preferably 62:38 to 57:43. If the range is satisfied, thermal stability, high-temperature life characteristics, capacity characteristics, and resistance characteristics may be achieved simultaneously and excellently.

The positive electrode material may include a first positive electrode active material and a second positive electrode active material having different average particle diameters ($D_{50}$). Preferably, the average particle diameter ($D_{50}$) of the first positive electrode active material may be larger than the average particle diameter ($D_{50}$) of the second positive electrode active material. In this case, manganese elution from the first positive electrode active material may be more effectively suppressed, and as a result, the high-temperature storage characteristics and high-temperature cycle characteristics of the battery may be further improved. In addition, in the rolling process of an electrode, the second positive electrode active material having a small particle diameter is filled into the pores of the first positive electrode active material having a large particle diameter, thereby increasing the positive electrode density and realizing a high energy density, so that excellent capacity characteristics may be achieved.

Specifically, the ratio of the average particle diameter ($D_{50}$) of the first positive electrode active material and the second positive electrode active material may be 5:1 to 1.5:1, preferably 4.5:1 to 1.7:1, more preferably 4:1 to 2:1, even more preferably 3.5:1 to 2:1, and even more preferably 3:1 to 2:1. If the range is satisfied, the high-temperature life characteristics and capacity characteristics may be further improved.

Hereinafter, the first positive electrode active material and the second positive electrode active material will be described in detail.

**(1) First Positive Electrode Active Material**

The first positive electrode active material includes a lithium manganese-based oxide having a spinel structure.

If the lithium manganese-based oxide having a spinel structure is included, there are advantages in being inexpensive, advantageous in terms of cost, non-toxic, and capable of achieving a positive electrode active material having excellent electrochemical and thermal stability.

The lithium manganese-based oxide may have a composition represented by [Formula 1] below.

$$[\text{Formula 1}] \qquad Li_{1+a1}Mn_{2-x1}M^1_{x1}O_{4-y1}A_{y1}$$

In Formula 1, $M^1$ is a doping element substituted for a manganese site in a lithium manganese-based oxide, and specifically, may be one or more doping elements selected from the group consisting of Al, Li, Mg, Zn, B, W, Ni, Co, Fe, Cr, V, Ru, Cu, Cd, Ag, Y, Sc, Ga, In, As, Sb, Pt, Au and Si, and preferably, $M^1$ may be one or more doping elements selected from the group consisting of Al, B, Li, Mg and Zn.

A is an element substituted for an oxygen site in a lithium manganese-based oxide, and may be one or more elements selected from the group consisting of F, Cl, Br, I, At and S.

Meanwhile, 1+a1 represents the molar ratio of lithium in the lithium manganese-based oxide, and may be $0 \leq a1 \leq 0.4$, preferably $0.1 \leq a1 \leq 0.4$, and more preferably $0.25 \leq a1 \leq 0.35$.

x1 represents the molar ratio of the doping element $M^1$ in the lithium manganese-based oxide, and may be $0 < x1 \leq 0.5$, preferably $0.03 \leq x1 \leq 0.25$. If the molar ratio x1 of $M^1$ satisfies the range, a structurally stable positive electrode active material may be obtained while minimizing the capacity decrease of a lithium secondary battery including the lithium manganese-based oxide.

y1 represents the molar ratio of element A in the lithium manganese-based oxide, and may be $0 \leq y1 \leq 0.1$, preferably $0.01 \leq y1 \leq 0.05$.

The lithium manganese-based oxide represented by Formula 1 above includes a doping element $M^1$ having a low oxidation number, so that the average oxidation number of the Mn ion is relatively high, thereby minimizing the structural deformation (Jahn-Teller distortion) due to $Mn^{3+}$ during charging and discharging, and thus reducing the occurrence of manganese (Mn) elution at high temperatures.

The lithium manganese-based oxide may include $M^1$ in 0.5 wt% to 3 wt% based on the total weight of the lithium manganese-based oxide, preferably 0.8 wt% to 2.5 wt%, more preferably 1.0 wt% to 2.0 wt%, and even more preferably 1.3 wt% to 1.6 wt%. If the range is satisfied, the structural deformation due to $Mn^{3+}$ during charging and discharging is minimized, thereby reducing the occurrence of manganese elusion at high temperatures, and excellent thermal stability may be realized by including Mn in the lithium manganese-based oxide at a sufficient molar ratio.

The lithium manganese-based oxide may include a first coating layer, and the first coating layer may be positioned on the surface of the lithium manganese-based oxide.

The first coating layer may block contact between the lithium manganese-based oxide and an electrolyte, thereby suppressing gas generation during charging and discharging, and preventing manganese (Mn) from being eluted at high temperatures.

The first coating layer may include one or more elements (hereinafter referred to as a 'coating element') selected from the group consisting of Al, Ti, W, F, P, Mg, Ni, Co, Fe, Cr, V, Cu, Ca, Zn, Zr, Nb, Mo, Sr, Sb, Bi, Si, S, and B, and preferably may include one or more elements selected from the group consisting of Al, Ti, Zn, W, and B, and more preferably may include one or more elements selected from the group consisting of B, W, and Al. If the first coating layer includes the coating element, the phenomenon of manganese being eluted by HF formed by the side reaction with the electrolyte may be more effectively suppressed.

Meanwhile, the first coating layer may be formed continuously or discontinuously on the surface of the lithium manganese-based oxide represented by [Formula 1] above.

For example, the first coating layer may be formed in a form in which particles including the coating elements are discontinuously attached to the surface of the lithium manganese-based oxide. In this case, the particles including the coating elements may be oxide particles such as $ZnO$, $Al_2O_3$, $TiO_2$, $WO_3$, $MgO$, $CaO$, $B_2O_3$, $NbO_2$, $SrO$, $CrO$, $Mo_2O_5$, $Bi_2O_3$, and $SiO$. If the oxide particles exist on the surface of the lithium manganese-based oxide particles, as shown in Reaction 1 below, since the oxide particles capture and decompose HF formed by the reaction with an electrolyte, the Mn eluted by HF is more suppressed.

[Reaction 1] $B_2O_3 + 6HF \rightarrow 2BF_3 + 3H_2O$ $ZnO + 2HF \rightarrow ZnF_2 + H_2O$ $Al_2O_3 + 6HF \rightarrow 2AlF_3 + 3H_2O$

Alternatively, the first coating layer may be formed in the form of a film containing the coating elements on the surface of the lithium manganese-based oxide. If the first coating layer is formed in the form of a film, the effect of blocking contact between the electrolyte and the lithium manganese-based oxide and the effect of suppressing manganese elution are more excellent. If the first coating layer in the form of a film above is formed on the surface of the lithium manganese-based oxide particle, the contact with the electrolyte is blocked by the first coating layer, thereby further suppressing side reactions with the electrolyte and gas generation.

The first coating layer may be included in 0.05 wt% to 0.3 wt% based on the total weight of the first positive electrode active material, preferably 0.07 wt% to 0.25 wt%, more preferably 0.08 wt% to 0.2 wt%, and even more preferably 0.09 wt% to 0.13 wt%. If the range is satisfied, the increase in resistance of the positive electrode due to the first coating layer may be minimized, while effectively blocking contact between the electrolyte and the lithium manganese-based oxide, thereby reducing manganese elution at high temperatures.

Meanwhile, the first coating layer may be formed in an area corresponding to 50 to 100% of the total surface area of the lithium manganese-based oxide, preferably 80 to 100%, and more preferably 90 to 100%. If the first coating layer formation area satisfies the range, the contact between the electrolyte and the lithium manganese-based oxide may be effectively blocked.

In addition, the lithium manganese-based oxide is particles in a single particle form.

Conventionally, in the case of lithium manganese-based oxide in the form of secondary particles in which tens to hundreds of primary particles are aggregated, the primary particles are likely to break during a rolling process during the manufacture of a positive electrode, and cracks may occur inside the particles during charging and discharging processes. Accordingly, since the contact area with the electrolyte increases, the amount of gas generated due to the side reaction with the electrolyte may increase, and manganese elution occurs more due to HF formed by the reaction with the electrolyte at high temperatures, which further increases the deterioration of the active material, and there is a problem that life characteristics at high temperatures are reduced.

Accordingly, the positive electrode active material according to the present invention includes a first positive electrode active material including lithium manganese-based oxide particles in a single particle form, so that the particle strength is higher than that of the conventional lithium manganese-based oxide in the form of secondary particles, so that the particle breakage is less during rolling, and since the number of sub-particle units constituting the particle is small, the change due to volume expansion and contraction of the sub-particle units during charging and discharging is small, so that the occurrence of cracks inside the particle is also significantly reduced. As the occurrence of particle breakage and internal cracks is reduced, the contact area between the lithium manganese-based oxide and the electrolyte becomes smaller, so that manganese elution due to the reaction with the electrolyte at high temperatures may be suppressed, thereby improving high-temperature storage characteristics and high-temperature life characteristics, and reducing gas generation due to electrolyte side reactions.

Meanwhile, the average particle diameter ($D_{50}$) of the first positive electrode active material may be 5 $\mu$m to 20 $\mu$m. Specifically, the average particle diameter ($D_{50}$) of the first positive electrode active material may be 5 $\mu$m or more, 6 $\mu$m or more, 7 $\mu$m or more, 8 $\mu$m or more, 9 $\mu$m or more, 10 $\mu$m or more, 11 $\mu$m or more, and may be 20 $\mu$m or less, 19 $\mu$m or less, 18 $\mu$m or less, 17 $\mu$m or less, 16 $\mu$m or less, 15 $\mu$m or less, 14 $\mu$m or less, or 13 $\mu$m or less. For example, the average particle diameter ($D_{50}$) of the first positive electrode active material may be 5 $\mu$m to 20 $\mu$m, preferably 7 $\mu$m to 18 $\mu$m, more preferably 10 $\mu$m to 15 $\mu$m, and even more preferably 11 $\mu$m to 14 $\mu$m. If the range of the average particle diameter is satisfied, the structural stability of the first positive electrode active material may be excellent, side reactions with the electrolyte may be small, and manganese elution amount at high temperatures may be small.

**(2) Second Positive Electrode Active Material**

The second positive electrode active material has a layered structure and includes a lithium nickel-based oxide containing nickel (Ni), cobalt (Co), manganese (Mn) and aluminum (Al). If the lithium nickel-based oxide is included, high capacity may be realized by having a high energy density, the second positive electrode active material may be structurally stable by including aluminum having a strong bonding force with oxygen atoms, and thus cation mixing may be suppressed during charging and discharging to be electrochemically stable at high potentials, and as a result, thermal stability and capacity characteristics may be further improved compared to ternary lithium nickel-based oxides containing nickel, cobalt, and manganese.

First, the lithium nickel-based oxide has a layered structure. Therefore, a positive electrode active material having excellent capacity characteristics and structural stability may be realized.

Meanwhile, the lithium nickel-based oxide may contain nickel at 90 mol% or more of the total metals excluding lithium, preferably 91 mol% or more, more preferably 92 mol% or more, and even more preferably 93 mol% or more. If the range is satisfied, high capacity characteristics may be achieved by the lithium nickel-based oxide, so that the capacity problem of the lithium manganese-based oxide having a spinel structure may be solved.

Specifically, the lithium nickel-based oxide may have a composition represented by [Formula 2] below.

$$[Formula\ 2] \qquad Li_{a2}[Ni_{x2}Co_{y2}Mn_{z2}Al_{w2}M^2{}_{v2}]O_2$$

In Formula 2, $M^2$ may be one or more doping elements selected from the group consisting of W, Cu, Fe, V, Cr, Ti, Zr, Zn, In, Ta, Y, La, Sr, Ga, Sc, Gd, Sm, Ca, Ce, Nb, Mg, B, and Mo, and preferably may be one or more doping elements selected from the group consisting of W, Y, Ba, Ca, Ti, Mg, Ta, and Nb.

In addition, in Formula 2, $0.8 \leq a2 \leq 1.2$, $0.9 \leq x2 < 1$, $0 < y2 \leq 0.2$, $0 < z2 \leq 0.2$, $0 < w2 \leq 0.2$, and $0 \leq v2 \leq 0.1$.

Specifically, a2 may mean the molar ratio of lithium (Li) in the lithium nickel-based oxide, and may be $0.8 \leq a2 \leq 1.2$, preferably $0.9 \leq a2 \leq 1.15$, and more preferably $1.0 \leq a2 \leq 1.1$. If a2 is less than 0.8, there is a concern that the capacity may be reduced, and if a2 exceeds 1.2, the particles may be sintered during a calcining process, making it difficult to manufacture the second positive electrode active material. Therefore, if the range is satisfied, a balance between the remarkable effect of improving the capacity characteristics of the second positive electrode active material according to the control of the Li content and the sinterability during the manufacture of the second positive electrode active material may be achieved.

x2 may mean the molar ratio of nickel among the total metals excluding lithium in the lithium nickel-based oxide, and may be $0.9 \leq x2 < 1$, preferably $0.91 \leq x2 < 1$, more preferably $0.92 \leq x2 < 1$, and even more preferably $0.93 \leq x2 < 1$. If the range is satisfied, a nickel content sufficient to contribute to charging and discharging in the lithium nickel-based oxide is secured, thereby facilitating high capacity.

y2 may mean the molar ratio of cobalt among the total metals excluding lithium in the lithium nickel-based oxide, and may be $0 < y2 \leq 0.2$, preferably $0 < y2 \leq 0.18$, more preferably $0.01 \leq y2 \leq 0.15$, even more preferably $0.03 \leq y2 \leq 0.12$, and even more preferably $0.05 \leq y2 \leq 0.10$. If the range is satisfied, good resistance characteristics and output characteristics may be achieved while having a cost advantage by including cobalt in a small content.

z2 may means the molar ratio of Mn among the total metals excluding lithium in the lithium nickel-based oxide, and may be $0 < z2 \leq 0.2$, preferably $0 < z2 \leq 0.18$, more preferably $0.01 \leq z2 \leq 0.15$, and even more preferably $0.03 \leq z2 \leq 0.10$. If the range is satisfied, the structural stability of the lithium nickel-based oxide may be improved.

w2 may mean the molar ratio of Al among the total metals excluding lithium in the lithium nickel-based oxide, and may be $0 < z2 \leq 0.2$, preferably $0 < z2 \leq 0.18$, more preferably $0.01 \leq z2 \leq 0.15$, and even more preferably $0.03 \leq z2 \leq 0.10$. If the range is satisfied, the structural stability of the lithium nickel-based oxide may be further improved.

v2 may mean the molar ratio of $M^3$ among the total metals excluding lithium in the lithium nickel-based oxide, and may be $0 \leq w2 \leq 0.1$, preferably $0 \leq w2 \leq 0.08$, more preferably $0 \leq w2 \leq 0.05$.

The lithium nickel-based oxide may include a second coating layer, and the second coating layer may be positioned on the surface of the lithium nickel-based oxide.

The second coating layer may block contact between the lithium nickel-based oxide and the electrolyte to suppress the occurrence of electrolyte side reactions, improve life characteristics if applied to a battery, and increase the filling density of the positive electrode material.

The second coating layer may include one or more elements (hereinafter referred to as "coating element") selected from the group consisting of Ti, W, B, F, P, Mg, Ni, Fe, Cr, V, Cu, Ca, Zn, Zr, Nb, Mo, Sr, Sb, Bi, Si, S, Co, and Al, and preferably may include one or more elements selected from the group consisting of Co and Al.

The second coating layer may be included in 0.01 wt% to 5 wt% based on the total weight of the second positive electrode active material, preferably 0.03 wt% to 4 wt%, more preferably 0.04 wt% to 3 wt%, and even more preferably 0.05 wt% to 2 wt%. If the range is satisfied, the occurrence of a side reaction between a lithium nickel-based oxide and an electrolyte may be more effectively suppressed, and the life characteristics may be further improved if applied to a battery.

According to an embodiment, if the second coating layer includes Co, the second coating layer may be included in 0.5 wt% to 5 wt% based on the total weight of the second positive electrode active material, preferably 1 wt% to 4 wt%, more preferably 2 wt% to 3 wt%.

According to another embodiment, if the second coating layer includes Al, the second coating layer may be included in 0.01 wt% to 0.1 wt% based on the total weight of the second positive electrode active material, preferably 0.02 wt% to 0.08 wt%, more preferably 0.03 wt% to 0.07 wt%.

The second coating layer may be formed on the entire surface of the second positive electrode active material, or may be formed partially. Specifically, if the second coating layer is partially formed on the surface of the second positive electrode active material, it may be formed in an area of 5% or more and less than 100%, preferably 20% or more and less than 100% of the total surface area of the second positive electrode active material.

In addition, the lithium nickel-based oxide is a particle in a single particle form.

If the lithium nickel-based oxide, which is a particle in a single particle form, is included together with the lithium manganese-based oxide having a spinel structure, the manganese elution amount at high temperatures may be significantly reduced compared to a case where the lithium nickel-based oxide in the form of secondary particles is included, and thus, a lithium secondary battery using the positive electrode material according to the present invention may have excellent high-temperature storage characteristics and high-temperature cycle characteristics. In addition, the initial resistance may be excellent, and the initial discharge capacity may be improved.

Meanwhile, the average particle diameter ($D_{50}$) of the second positive electrode active material may be 1 $\mu$m to 10 $\mu$m. Specifically, the average particle diameter ($D_{50}$) of the second positive electrode active material may be 1 $\mu$m or more, 1.5 $\mu$m or more, 2 $\mu$m or more, 2.5 $\mu$m or more, 3 $\mu$m or more, 3.5 $\mu$m or more, 4 $\mu$m or more, and may be 10 $\mu$m or less, 9.5 $\mu$m or less, 9 $\mu$m or less, 8.5 $\mu$m or less, 8 $\mu$m or less, 7.5 $\mu$m or less, 7 $\mu$m or less, 6.5 $\mu$m or less, 6 $\mu$m or less, 5.5 $\mu$m or less, 5 $\mu$m or less, 4.5 $\mu$m or less, or 4 $\mu$m or less. For example, the average particle diameter ($D_{50}$) of the second positive electrode active material may be 1 $\mu$m to 10 $\mu$m, preferably 2 $\mu$m to 8 $\mu$m, more preferably 2.5 $\mu$m to 6.5 $\mu$m, and even more preferably 3 $\mu$m to 5 $\mu$m. If the range is satisfied, side reactions with the electrolyte may be minimized while preventing an increase in resistance and a decrease in output characteristics.

## Lithium Secondary Battery

Next, a lithium secondary battery according to the present invention will be described.

The lithium secondary battery according to the present invention includes: an electrode assembly; an electrolyte; and a battery case accommodating the electrode assembly and the electrolyte. In this case, the electrode assembly includes a positive electrode including the positive electrode material according to the present invention described above, a negative electrode, and a separator interposed between the positive electrode and the negative electrode.

Hereinafter, each component of the lithium secondary battery according to the present invention will be described in more detail.

## (1) Electrode Assembly

The electrode assembly according to the present invention includes a positive electrode, a negative electrode, and a separator interposed between the positive electrode and the negative electrode.

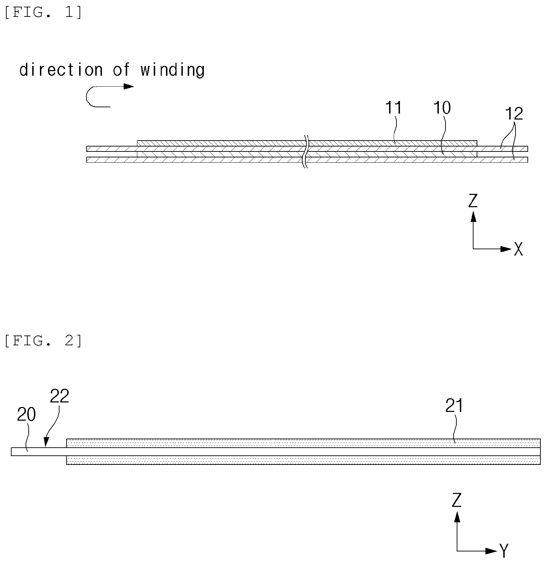

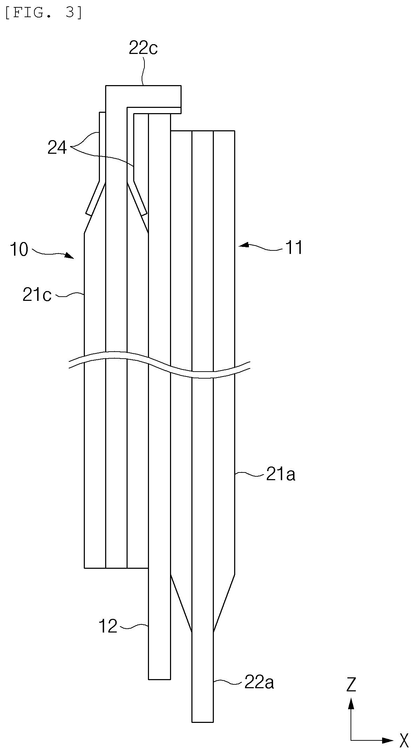

FIG. 1 illustrates a laminate structure of an electrode assembly before winding, according to an embodiment of the present invention, FIG. 2 illustrates a cross-sectional structure of an electrode (positive electrode or negative electrode) according to an embodiment of the present invention, and FIG. 3 illustrates a structure of an electrode assembly according to an embodiment of the present invention.

Referring to FIGS. 1 and 2, the electrode assembly (A) of the present invention may be manufactured by winding a laminate formed by sequentially laminating a separator (12), a positive electrode (10), a separator (12), and a negative electrode (11) at least once in one direction (X).

In this case, the positive electrode (10) and the negative electrode (11) have a structure in which an active material layer (21) is formed on a long sheet-shaped current collector (20), and may include a non-coated part (22) in which an active material layer (21) is not formed in a partial area of the current collector (20).

By using the positive electrode (10) and the negative electrode (11) including the non-coated part (22) as described above, a battery having a structure in which at least a portion of the non-coated part of the positive electrode (10) and the negative electrode (11) defines an electrode tab may be achieved without providing a separate electrode tab.

Specifically, the non-coated part (22) may be formed lengthwise along the winding direction (X) at one end of the current collector (20), and by combining a current collector plate to each of the positive electrode non-coated part and the negative electrode non-coated part, and by connecting the current collector plate to an electrode terminal, the non-coated part may function as an electrode tab.

For example, a battery in which the positive electrode non-coated part and the negative electrode non-coated part function as electrode tabs may be manufactured by the method below. First, a separator, a positive electrode, a separator, and a negative electrode are sequentially laminated so that the positive electrode non-coated part and the negative electrode non-coated part are positioned in opposite directions, and then wound in one direction to manufacture a jelly-roll type electrode assembly. Then, the non-coated parts of the positive and negative electrodes are bended toward the winding center (C), and then current collector plates are welded to the positive electrode non-coated part and the negative electrode non-coated part, respectively, and the current collector plates are connected to the electrode terminals to manufacture a battery. The current collector plate has a large cross-sectional area compared to a strip-type electrode tab, and since the resistance is inversely proportional to the cross-sectional area of the passage through which the current flows, if the secondary battery is formed with the above-mentioned structure, cell resistance may be significantly reduced.

Meanwhile, the positive and negative electrode non-coated parts may be processed into a plurality of independently bendable segments, and at least some of the plurality of segments may be bended toward the winding center (C) of the electrode assembly.

The segments may be formed by processing the current collectors of the positive and negative electrodes through a metal foil cutting process such as laser notching, ultrasonic cutting, and punching.

If the non-coated parts of the positive and negative electrodes are processed into a plurality of segments, the stress applied to the non-coated part during bending may be reduced, thereby preventing deformation or damage to the non-coated part, and the welding characteristics with the current collector plate may be improved.

The current collector plate and the non-coated part are generally joined by welding, and in order to improve the welding characteristics, a strong pressure is required to be applied to the welding area of the non-coated part to bend the non-coated part as flat as possible. However, during the bending process, the shape of the non-coated part may be non-uniformly distorted and deformed, and the deformed portion may contact an electrode of the opposite polarity, causing an internal short circuit or causing microscopic cracks in the non-coated part. However, if the non-coated parts of the positive and negative electrodes are processed into a plurality of independently bendable segments, the stress applied to the non-coated part during bending may be alleviated, thereby minimizing deformation and damage to the non-coated part.

In addition, if the non-coated part is processed into a segmented form as described above, overlap occurs between the plurality of segments during bending, which increases the welding strength with the current collector plate, and if using the latest technology such as laser welding, the problem of the laser penetrating into the electrode assembly and melting the separator or active material may be prevented. Preferably, at least some of the bended plurality of segments may overlap on the upper and lower sides of the electrode assembly, and the current collector plate may be bonded on the overlapped plurality of segments.

Meanwhile, the electrode assembly according to the present invention may be formed with a structure in which an insulating layer (24) is additionally formed on the positive electrode (10), as illustrated in FIG. 3. Specifically, the insulating layer (24) may be formed to cover a portion of the positive electrode active material layer and a portion of the non-coated part along a direction parallel to the winding direction of the electrode assembly.

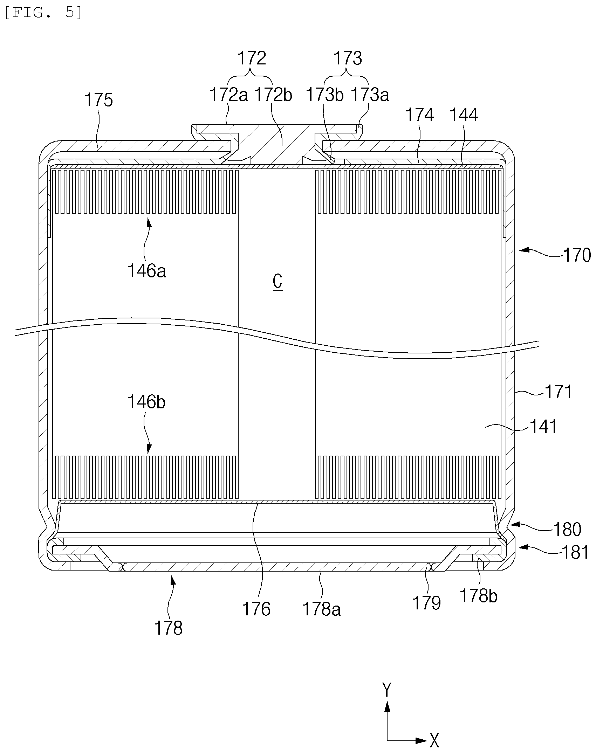

In the case of a battery having a tab-less structure in which the non-coated part (22c) of the positive electrode (10) and the non-coated part (22a) of the negative electrode (11) are used as electrode tabs, the electrode assembly is formed so that the positive electrode (10) protrudes above the separator (12) and the negative electrode (11) protrudes below the separator (12), and the protruding positive electrode (10) and/or negative electrode (11) are bended and then combined with current collector plates. However, if the positive electrode (10) or negative electrode (11) is bended as described above, the current collector of the positive electrode (10) or negative electrode (11) is positioned close to the electrode of the opposite polarity beyond the separator, which may cause electrical contact between the positive electrode and the negative electrode, thereby causing an internal short circuit. However, as illustrated in FIG. 5, if an insulating layer (24) covering a portion of the positive electrode active material layer and the non-coated part is formed, the positive electrode (10) and negative electrode (11) may be prevented from electrically contacting each other by the insulating layer (24), thereby preventing a short circuit from occurring inside the battery.

Preferably, the insulating layer (24) may be provided on at least one surface of the current collector of the positive electrode (10), and preferably, may be provided on both surfaces of the positive electrode (10).

In addition, the insulating layer (24) may be formed in an area of the positive electrode (10) that is likely to face the active material layer (21a) of the negative electrode (11). For example, on the surface of the non-coated part (22c) of the positive electrode (10), that faces the negative electrode (11) after being bended, an insulating layer (24) may be formed to extend to the end of the non-coated part (22c). However, in the case of the surface opposite to the surface facing the negative electrode (11) after being bended, it is preferable that the insulating layer (24) is formed only on a portion of the non-coated part (22c), for example, up to the point of bending of the non-coated part (22c). This is because if the insulating layer (24) is formed on the entire area of the non-coated part on the surface opposite to the surface facing the negative electrode (11), electrical contact with the current collector plate is impossible, and thus the non-coated part may not function as an electrode tab.

Meanwhile, the material or component of the insulating layer (24) is not particularly limited as long as it may be attached to the positive electrode while securing insulating performance. For example, the insulating layer may be an insulating coating layer or an insulating tape, and the insulating coating layer may include an organic binder and inorganic particles. In this case, the organic binder may be, for example, styrene-butadiene rubber (SBR), and the inorganic particles may be, but are not limited to, alumina oxide.

Hereinafter, the positive electrode, negative electrode, and separator constituting the electrode assembly will be described in detail.

**1) Positive Electrode**

The positive electrode may be manufactured by applying a positive electrode slurry to one side or both sides of a long sheet-shaped positive electrode current collector, removing the solvent of the positive electrode slurry through a drying process, and then rolling. Meanwhile, a positive electrode including a non-coated part may be manufactured by not applying the positive electrode slurry to a portion of the positive electrode collector, for example, one end of the positive electrode collector when applying the positive electrode slurry.

In addition, the positive electrode slurry may be prepared by dispersing the positive electrode material according to the present invention in a solvent such as dimethyl sulfoxide (DMSO), isopropyl alcohol, N-methylpyrrolidone (NMP), acetone, and water.

The positive electrode manufactured thereby includes the positive electrode material. Specifically, the positive electrode includes a positive electrode current collector and a positive electrode active material layer, and the positive electrode active material layer may include the positive electrode material.

Meanwhile, various positive electrode current collectors used in the relevant technical field may be used as the positive electrode current collector. For example, as the positive electrode current collector, stainless steel, aluminum, nickel, titanium, calcined carbon, or aluminum or stainless steel, surface-treated with carbon, nickel, titanium, silver, or the like may be used. The positive electrode current collector may typically have a thickness of 3 to 500 $\mu$m, and may form fine irregularities on the surface of the positive electrode current collector to increase the adhesive strength of the positive electrode active material. The positive electrode current collector may be used in various forms such as a film, a sheet, a foil, a net, a porous body, a foam and a non-woven fabric.

The positive electrode active material layer may be positioned on the positive electrode current collector, and specifically, may be positioned on one side or both sides of the positive electrode current collector. The positive electrode active material layer may have a single layer or a multilayer structure of two or more layers.

Since the positive electrode material is the same as described above, the detailed description thereof will be omitted.

Meanwhile, the positive electrode active material layer may optionally further include at least one of a positive electrode conductive material and a positive electrode binder.

The positive electrode conductive material is used to provide the electrode with conductivity, and in the battery to be formed, if it does not cause a chemical change and has electronic conductivity, it may be used without specific limitations. Specific examples include: graphite such as natural graphite or artificial graphite; carbon-based materials such as carbon black, acetylene black, Ketjen black, channel black, furnace black, lamp black, thermal black, carbon fiber, and carbon nanotube; metal powder or metal fiber of copper, nickel, aluminum, and silver; conductive whiskers of zinc oxide and potassium titanate; conductive metal oxides such as titanium oxide; or conductive polymers such as polyphenylene derivatives, and one of them may be used alone or a mixture of two or more may be used. The positive electrode conductive material may be typically included in 1 to 30 wt%, preferably 1 to 20 wt%, and more preferably 1 to 10 wt%, based on the total weight of the positive electrode active material layer.

The positive electrode binder serves to improve the adhesion between positive electrode particles and the adhesive strength between the positive electrode material and the positive electrode current collector, and specific examples thereof include a fluorine resin-based binder including polyvinylidene fluoride (PVDF) or polytetrafluoroethylene (PTFE); a rubber-based binder including styrene butadiene rubber (SBR), acrylonitrile-butadiene rubber, and styreneisoprene rubber; a cellulose-based binder including carboxyl methyl cellulose (CMC), starch, hydroxy propyl cellulose, and regenerated cellulose; a polyalcohol-based binder including polyvinyl alcohol; a polyolefin-based binder including polyethylene and polypropylene; a polyimide-based binder; and a polyester-based binder, and a silane-based binder, and one of them may be used alone or a mixture of two or more may be used. The positive electrode binder may be included in an amount of 1 to 30 wt%, preferably 1 to 20 wt%, and more preferably 1 to 10 wt%, based on the total weight of the positive electrode active material layer.

**2) Negative electrode**

The negative electrode may be manufactured by applying a negative electrode slurry to one side or both sides of a long sheet-shaped negative electrode current collector, removing the solvent of the negative electrode slurry through a drying process, and then rolling. Meanwhile, a negative electrode including a non-coated part may be manufactured by not applying the negative electrode slurry to a portion of the negative electrode current collector, for example, one end of the negative electrode current collector, when applying the negative electrode slurry.

The negative electrode slurry may be prepared by dispersing the negative electrode active material in a solvent such as distilled water, ethanol, methanol, and isopropyl alcohol.

Alternatively, the negative electrode may be manufactured by casting the negative electrode slurry on a separate support, and then laminating the film obtained by peeling it off from the support onto the negative electrode current collector.

The negative electrode manufactured thus includes a negative electrode active material. Specifically, the negative electrode includes a negative electrode current collector and a negative electrode active material layer, and the negative electrode active material layer may include a negative electrode active material.

The negative electrode current collector is not particularly limited as long as it has high conductivity without causing chemical changes in the battery, and for example, copper, stainless steel, aluminum, nickel, titanium, calcined carbon, copper or stainless steel, surface-treated with carbon, nickel, titanium, silver, or the like, aluminum-cadmium alloy, or the like may be used. The negative electrode current collector may typically have a thickness of 3 to 500 $\mu$m.

In addition, the negative electrode current collector, like the positive electrode current collector, may form fine unevenness on the surface of the current collector to strengthen the bonding force of the negative electrode active material. For example, it can be used in various forms such as a film, a sheet, a foil, a net, a porous body, a foam, and a non-woven fabric.

The negative active material layer may be positioned on the negative electrode current collector, and specifically, may be positioned on one side or both sides of the negative electrode current collector. The negative active material layer may have a single layer or a multilayer structure of two or more layers.

As the negative electrode active material, a compound capable of reversible intercalation and deintercalation of lithium may be used, and the type thereof is not particularly limited. Specific examples include carbonaceous materials such as artificial graphite, natural graphite, graphitized carbon fiber, and amorphous carbon; (semi-)metallic materials capable of alloying with lithium, such as Si, Al, Sn, Pb, Zn, Bi, In, Mg, Ga, Cd, Si alloy, Sn alloy, or Al alloy; (semi-)metallic oxides capable of doping and dedoping lithium, such as $SiO_\beta$ (0<$\beta$<2), $SnO_2$, vanadium oxide, and lithium vanadium oxide; or a composite containing the (semi-)metallic material and a carbonaceous material, such as a Si-C composite or a Sn-C composite, and one or a mixture of two or more of thereof may be used.

In addition, a metallic lithium thin film may be used as the negative electrode active material. In addition, both low-crystalline carbon and high-crystalline carbon may be used as the carbon material. Representative examples of low-crystalline carbon include soft carbon and hard carbon, and representative examples of high-crystalline carbon include amorphous, plate-like, flaky, spherical or fiber-like natural or artificial graphite, Kish graphite, pyrolytic carbon, mesophase pitch-based carbon fiber, meso-carbon microbeads, mesophase pitches, and high-temperature calcined carbon such as petroleum or coal tar pitch derived cokes.

The negative electrode active material may be included in the negative electrode active material layer at 60 wt% to 99 wt%, preferably 75 wt% to 95 wt%.

Meanwhile, the negative electrode active material layer may optionally further include a negative electrode conductive material and a negative electrode binder in addition to the negative electrode active material.

The negative electrode conductive material is used to provide the electrode with conductivity, and in the battery to be formed, if it does not cause a chemical change and has electronic conductivity, it may be used without specific limitations. Specific examples include graphite such as natural graphite and artificial graphite; carbon-based material such as carbon black, acetylene black, Ketjen black, channel black, furnace black, lamp black, thermal black, carbon fiber, carbon nanotube, or the like; metal powder or metal fiber of copper, nickel, aluminum, silver, or the like; conductive whiskers of zinc oxide, potassium titanate, or the like; conductive metal oxides such as titanium oxide; or conductive polymers such as polyphenylene derivatives, and one of them may be used alone or a mixture of two or more may be used. The negative electrode conductive material may be included in an amount of typically 1 to 30 wt%, preferably 1 to 20 wt%, and more preferably 1 to 10 wt%, based on the total weight of the negative electrode active material layer.

The negative electrode binder serves to improve the adhesion between negative electrode active material particles and the adhesive strength between the negative electrode active material and the negative electrode current collector. Specific examples thereof include polyvinylidene fluoride (PVDF), vinylidene fluoride-hexafluoropropylene copolymer (PVDF-co-HFP), polyvinyl alcohol, polyacrylonitrile, carboxymethyl cellulose (CMC), starch, hydroxypropyl cellulose, regenerated cellulose, polyvinyl pyrrolidone, polytetrafluoroethylene, polyethylene, polypropylene, ethylene-propylene-diene monomer rubber (EPDM rubber), sulfonated-EPDM, styrene-butadiene rubber (SBR), fluororubber, or various copolymers thereof, and one of them may be used alone or a mixture of two or more thereof may be used. The negative electrode binder may be included in an amount of 1 to 30 wt%, preferably 1 to 20 wt%, and more preferably 1 to 10 wt%, based on the total weight of the negative electrode active material layer.

## 3) Separator

Next, the separator is used to separate the negative electrode and the positive electrode and to provide a passage for lithium ions, and may be used without specific limitations if it is a separator commonly used in lithium secondary batteries. Specifically, the separator may be a porous polymer film, for example, a porous polymer film made of a polyolefin polymer such as an ethylene homopolymer, a propylene homopolymer, an ethylene/butene copolymer, an ethylene/hexene copolymer, and an ethylene/methacrylate copolymer, or a laminated structure of two or more layers thereof. In addition, the conventional porous nonwoven fabric, for example, a nonwoven fabric made of high-melting-point glass fibers, polyethylene terephthalate fibers, or the like may be used. In addition, a coated separator containing a ceramic component or a polymer material may be used to secure heat resistance or mechanical strength.

## (2) Electrolyte

The electrolyte according to the present invention includes a lithium salt and an organic solvent.

The lithium salt may be used without specific limitations if it is a compound capable of providing lithium ions used in a lithium secondary battery. Specifically, the lithium salt may be $LiPF_6$, $LiClO_4$, $LiAsF_6$, $LiBF_4$, $LiSbF_6$, $LiAlO_4$, $LiAlCl_4$, $LiCF_3SO_3$, $LiC_4F_9SO_3$, $LiN(C_2F_5SO_3)_2$, $LiN(C_2F_5SO_2)_2$, $LiN(CF_3SO_2)_2$, LiCl, LiI, or $LiB(C_2O_4)_2$. The concentration of the lithium salt may be in the range of 0.1 to 5.0 M, preferably 0.1 to 3.0 M. If the concentration of the lithium salt is within the range, the electrolyte may have appropriate conductivity and viscosity, thereby exhibiting excellent electrolyte performance, and lithium ions may effectively move.

The organic solvent may include at least one of a cyclic carbonate-based organic solvent, a linear carbonate-based organic solvent, a linear ester-based organic solvent, and a cyclic ester-based organic solvent.

The cyclic carbonate-based organic solvent is a high-viscosity organic solvent, and may typically include at least one organic solvent selected from the group consisting of ethylene carbonate (EC), propylene carbonate (PC), 1,2-butylene carbonate, 2,3-butylene carbonate, 1,2-pentylene carbonate, 2,3-pentylene carbonate, and vinylene carbonate.

In addition, the linear carbonate-based organic solvent is an organic solvent having low viscosity and low dielectric constant, and may typically include at least one organic solvent selected from the group consisting of dimethyl carbonate (DMC), diethyl carbonate (DEC), dipropyl carbonate, ethyl methyl carbonate (EMC), methyl propyl carbonate, and ethyl propyl carbonate, and may specifically include ethyl methyl carbonate (EMC).

The linear ester-based organic solvent may be, as a specific example, at least one organic solvent selected from the group consisting of methyl acetate, ethyl acetate, propyl acetate, methyl propionate, ethyl propionate, propyl propionate, and butyl propionate.

The cyclic ester-based organic solvent may be, as a specific example, at least one organic solvent selected from the group consisting of $\gamma$-butyrolactone, $\gamma$-valerolactone, $\gamma$-caprolactone, $\sigma$-valerolactone, and $\varepsilon$-caprolactone.

Preferably, the electrolyte according to the present invention may include ethylene carbonate and dimethyl carbonate as the organic solvent.

Meanwhile, the electrolyte may additionally include other additives in addition to the electrolyte components for the purpose of improving the life characteristics of the battery, suppressing the decrease in battery capacity, improving the discharge capacity of the battery, or the like.

The other additives may include at least one other additive selected from the group consisting of cyclic carbonate-based compounds, halogen-substituted carbonate-based compounds, sultone-based compounds, sulfate-based compounds, borate-based compounds, nitrile-based compounds, benzene-based compounds, amine-based compounds, silane-based compounds, and lithium salt-based compounds different from the lithium salt included in the electrolyte, as representative examples.

Specifically, the other additives include one or two or more compounds selected from the group consisting of vinylene carbonate (VC), vinyl ethylene carbonate, fluoroethylene carbonate (FEC), 1,3-propane sultone (PS), 1,4-butane sultone, ethene sultone, 1,3-propene sultone (PRS), 1,4-butene sultone, 1-methyl-1,3-propene sultone, ethylene sulfate (ESA), trimethylene sulfate (TMS), methyl trimethylene sulfate (MTMS), tetraphenylborate, lithium oxalyldifluoroborate, succinonitrile, adiponitrile, acetonitrile, propionitrile, butyronitrile, valeronitrile, caprylonitrile, heptanenitrile, cyclopentane carbonitrile, cyclohexane carbonitrile, 2-fluorobenzonitrile, 4-fluorobenzonitrile, difluorobenzonitrile, trifluorobenzonitrile, phenylacetonitrile, 2-fluorophenylacetonitrile, 4-fluorophenylacetonitrile, fluorobenzene, triethanolamine, ethylenediamine, tetravinylsilane, $LiN(SO_2F)_2$ (lithium bis(fluorosulfonyl)imide, LiFSI), $LiN(SO_2CF_3)_2$ (lithium bis(trifluoromethane sulfonyl)imide, LiTFSI), $LiPO_2F_2$, LiODFB, LiBOB (lithium bisoxalatoborate ($LiB(C_2O_4)_2$)) and $LiBF_4$.

The other additives may be included in an amount of 0.01 to 20 wt% based on the total weight of the electrolyte, preferably 0.05 to 5.0 wt%. If the content of the above other additives is less than 0.01 wt%, the effects of improving the low-temperature output of the battery and the high-temperature storage characteristics and high-temperature life characteristics may be insignificant, and if the content of the other additives exceeds 20 wt%, there is a possibility that side reactions in the electrolyte may occur excessively during charging and discharging of the battery. In particular, if the additives for forming an SEI film are added in excessive amounts, the additives may not be sufficiently decomposed at high temperatures and may exist as unreacted substances or precipitated substances in the electrolyte at room temperature. Accordingly, side reactions that reduce the life or resistance characteristics of the secondary battery may occur.

**(3) Battery Case**

The battery case is for accommodating the electrode assembly and the electrolyte, and various battery cases known in the art, for example, a cylindrical battery case, a prismatic battery case, a pouch-type battery case, or the like may be used.

Preferably, the lithium secondary battery according to the present invention may be a cylindrical battery having a cylindrical battery case, and may preferably be a large cylindrical battery having a form factor ratio (defined as a value obtained by dividing the diameter by the height of the cylindrical battery, that is, the ratio of the diameter (T) to the height (H)) of 0.4 or more, preferably 0.4 to 0.6. Here, the form factor means a value representing the diameter and height of the cylindrical battery.

The lithium secondary battery according to the present invention may be, for example, a 46110 cell (diameter 46 mm, height 110 mm, form factor ratio 0.418), a 48110 cell (diameter 48 mm, height 110 mm, form factor ratio 0.436), a 4880 cell (diameter 48 mm, height 80 mm, form factor ratio 0.600), or a 4680 cell (diameter 46 mm, height 80 mm, form factor ratio 0.575). In the numerical value representing the form factor, the first two numbers indicate the diameter of the cell, and the next two or three numbers indicate the height of the cell.

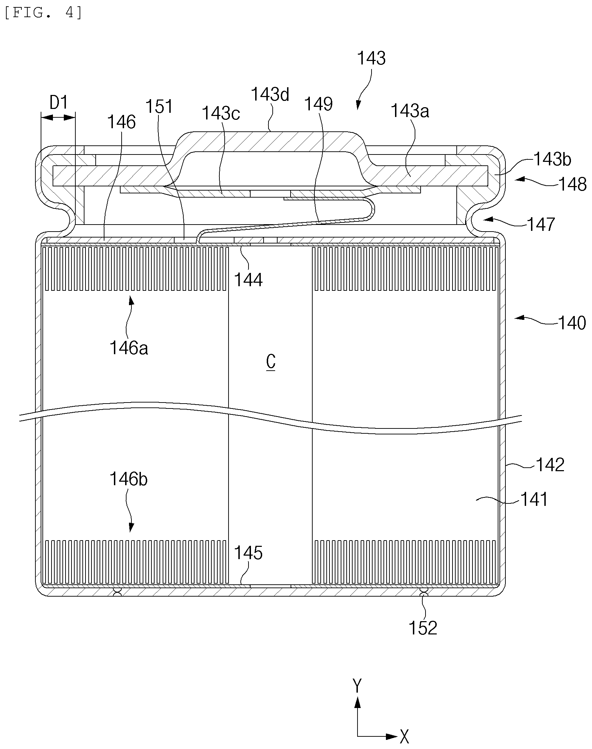

FIG. 4 and FIG. 5 disclose embodiment examples of the lithium secondary battery according to the present invention. Hereinafter, the lithium secondary battery according to the present invention will be described with reference to FIG. 4 and FIG. 5. However, FIG. 4 and FIG. 5 only show embodiments of the present invention, and the structure of the battery of the present invention is not limited to the scope disclosed in FIG. 4 and FIG. 5.

FIG. 4 shows a cross-sectional view of a lithium secondary battery according to an embodiment of the present invention.

Referring to FIG. 4, a lithium secondary battery (140) according to the present invention includes an electrode assembly (141), a battery case (142) in which the electrode assembly (141) and an electrolyte (not shown) are accommodated, and a sealant (143) that seals the open end of the battery case (142).

In this case, the electrode assembly may be a laminate of a positive electrode, a separator, and a negative electrode wound in one direction. In addition, the positive electrode and the negative electrode of the electrode assembly may each include a non-coated part in which an active material layer is not formed, and may be laminated and wound so that the positive electrode non-coated part and the negative electrode non-coated part are positioned at the top and bottom of the electrode assembly, respectively. Since the electrode assembly has been described above, only the remaining components except for the electrode assembly will be described below.

Meanwhile, the battery case (142) is a can-shaped container with an open end formed at the top, and is formed using a conductive metal material such as aluminum and steel. The battery case accommodates the electrode assembly (141) in the inner space through the upper open end, and also accommodates an electrolyte (not shown).

Meanwhile, it is preferable that the lithium secondary battery (140) of the present invention does not include a current interruption device (CID).

Meanwhile, as shown in FIG. 4, the battery case (142) is electrically connected to the non-coated part (146b) of the negative electrode, and may function as a negative electrode terminal that contacts an external power source and transmits current applied from the external power source to the negative electrode.

If necessary, a beading part (147) and a crimping part (148) may be provided at the top of the battery case (142). The beading part (147) may be formed by pressing the outer circumference of the battery case (142) to a distance of D1. The beading part (147) prevents the electrode assembly (141) accommodated inside the battery case (142) from coming out through the upper opening of the battery case (142), and may function as a support part on which the sealant (143) is secured.

The crimping part (148) may be formed on the upper portion of the beading part (147), and has an extended and bent shape to surround the outer circumference of a cap plate (143a) placed on the beading part (147) and a portion of the upper surface of the cap plate (143a).

Next, the sealant (143) is for sealing the open end of the battery case (142), and includes a cap plate (143a), a first gasket (143b) that provides airtightness between the cap plate (143a) and the battery case (142) and has insulation, and may further include a connection plate (143c) that is electrically and mechanically coupled to the cap plate (143a), if necessary. The cap plate (143a) is pressed onto the beading part (147) formed on the battery case (142), and may be fixed by the crimping part (148).

The cap plate (143a) is a component formed using a conductive metal material, and covers the upper opening of the battery case (142). The cap plate (143a) is electrically connected to the positive electrode of the electrode assembly (141), and is electrically insulated from the battery case (142) through the first gasket (143b). Therefore, the cap plate (143a) may function as a positive electrode terminal of a lithium secondary battery. The cap plate (143a) may have a protrusion part (143d) protruding upward from a center C, and the protrusion part (143d) may contact an external power source to allow current to be applied from the external power source.

A first gasket (143b) may be interposed between the cap plate (143a) and the crimping part (148) to secure the airtightness of the battery case (142) and to electrically insulate between the battery case (142) and the cap plate (143a).

Meanwhile, the lithium secondary battery (140) according to the present invention may further include current collector plates (144, 145), if necessary. The current collector plates are coupled to the positive electrode non-coated part (146a) and the negative electrode non-coated part (146b), and are connected to the electrode terminals (for example, positive electrode terminal and negative electrode terminal).

Specifically, the cylindrical battery (140) according to the present invention may include a first current collector plate (144) coupled to the upper portion of the electrode assembly (141) and a second current collector plate (145) coupled to the lower portion of the electrode assembly (141).

The first current collector plate (144) and/or the second current collector plate (145) may be further included.

The first current collector plate (144) is coupled to the upper portion of the electrode assembly (141). The first current collector plate (144) is formed using a conductive metal material such as aluminum, copper and nickel, and is electrically connected to the non-coated part (146a) of the positive electrode. A lead (149) may be connected to the first current collector plate (144). The lead (149) may extend upward from the electrode assembly (141) and be connected to the connection plate (143c) or may be directly connected to the lower surface of the cap plate (143a). The connection of the lead (149) to other components may be accomplished through welding. Preferably, the first current collector plate (144) may be formed integrally with the lead (149). In this case, the lead (149) may have a plate shape that extends outward from the center of the first current collector plate (144).

Meanwhile, the first current collector plate (144) is coupled to the end of the non-coated part (146a) of the positive electrode, and the coupling may be achieved by, for example, laser welding, resistance welding, ultrasonic welding, soldering or the like.

The second current collector plate (145) is coupled to the lower portion of the electrode assembly (141). The second current collector plate (145) is formed using a conductive metal material such as aluminum, copper, and nickel, and is electrically connected to the non-coated part (146b) of the negative electrode. One side of the second current collector plate (145) may be coupled to the non-coated part (146b) of the negative electrode, and the opposite side may be coupled to the inner bottom surface of the battery case (142). In this case, the coupling may be achieved by, for example, laser welding, resistance welding, ultrasonic welding, soldering or the like.

Meanwhile, the lithium secondary battery (140) according to the present invention may further include an insulator (146), if necessary. The insulator (146) may be disposed to cover the upper surface of the first current collector plate (144). Since the insulator (146) covers the first current collector plate (144), direct contact between the first current collector plate (144) and the inner surface of the battery case (142) may be prevented.

The insulator (146) has a lead hole (151) through which the lead (149) extending upward from the first current collector plate (144) may be drawn out. The lead (149) is drawn out upward through the lead hole (151) and coupled to the lower surface of the connection plate (143c) or the lower surface of the cap plate (143a).

The insulator (146) may be formed using a polymer resin having insulating properties, for example, a polymer resin material such as polyethylene, polypropylene, polyimide, and polybutylene terephthalate.

Meanwhile, the lithium secondary battery (140) according to the present invention may further include a venting part (152) formed on the lower surface of the battery case (142), if necessary. The venting part (152) corresponds to a region of the lower surface of the battery case (142) that has a thinner thickness compared to the surrounding region. Since the venting part (152) is thin, it is structurally weaker compared to the surrounding region. Therefore, if the pressure inside the lithium secondary battery (140) increases above a certain level, the venting part (152) may rupture, thereby allowing the gas inside the battery case (152) to be discharged to the outside, thereby preventing the battery from exploding.

FIG. 5 illustrates a cross-sectional view of a lithium secondary battery according to another embodiment of the present invention.

Referring to FIG. 5, a lithium secondary battery (170) according to another embodiment of the present invention has a different structure of a battery case and a sealant compared to the lithium secondary battery (140) illustrated in FIG. 4, and the configuration of an electrode assembly and an electrolyte is substantially the same.

Specifically, a lithium secondary battery (170) according to another embodiment of the present invention includes a battery case (171) in which a rivet terminal (172) is installed through the battery case. The rivet terminal (172) is installed in a partially closed closed surface (upper surface in the drawing) of one end of the battery case (171). The rivet terminal (172) is riveted to a through hole (first opening of the first end) of the battery case (171) while an insulating second gasket (173) is interposed therebetween. The rivet terminal (172) is exposed to the outside in a direction opposite to the gravity direction.

The rivet terminal (172) includes a terminal exposure part (172a) and a terminal insertion part (172b). The terminal exposure part (172a) is exposed to the outside of the closed surface of the battery case (171). The terminal exposure part (172a) may be positioned approximately at the center of the partially closed surface of the battery case (171). The maximum diameter of the terminal exposure part (172a) may be formed larger than the maximum diameter of the through hole formed in the battery case (171). The terminal insertion part (172b) may penetrate approximately at the center of the closed surface of the battery case (171) and be electrically connected to the non-coated part (146a) of the positive electrode. The terminal insertion part (172b) may be riveted onto the inner surface of the battery case (171). That is, an end of the terminal insertion part (172b) may have a shape that is bent toward the inner surface of the battery case (171). The maximum diameter of the end of the terminal insertion part (172b) may be larger than the maximum diameter of the through hole of the battery case (171).

The lower surface of the terminal insertion part (172b) may be welded to the first current collector plate (144) connected to the non-coated part (146a) of the positive electrode. An insulation cap (174) formed using an insulating material may be interposed between the first current collector plate (144) and the inner surface of the battery case (171). The insulation cap (174) covers the upper portion of the first current collector plate (144) and the upper edge portion of the electrode assembly (141). As a result, the outer non-coated part (B3) of the electrode assembly (141) may be prevented from coming into contact with the inner surface of the battery case (171) having a different polarity to cause a short circuit.

The terminal insertion part (172b) of the rivet terminal (172) may be welded to the first current collector plate (144) by penetrating the insulation cap (174).

The second gasket (173) is interposed between the battery case (171) and the rivet terminal (172) to prevent the battery case (171) and the rivet terminal (172) having opposite polarities from electrically contacting each other. As a result, the upper surface of the battery case (171) having a substantially flat shape may function as a positive electrode terminal of the lithium secondary battery (170).

The second gasket (173) includes a gasket exposure part (173a) and a gasket insertion part (173b). The gasket exposure part (173a) is interposed between the terminal exposure part (172a) of the rivet terminal (172) and the battery case (171). The gasket insertion part (173b) is interposed between the terminal insertion part (172b) of the rivet terminal (172) and the battery case (171). The gasket insertion part (173b) may be deformed together with the terminal insertion part (172b) during riveting and may be closely attached to the inner surface of the battery case (171). The second gasket (173) may be formed using, for example, an insulating polymer resin.

The gasket exposure part (173a) of the second gasket (173) may have an extended shape to cover the outer surface of the terminal exposure part (172a) of the rivet terminal (172). If the second gasket (173) covers the outer surface of the rivet terminal (172), a short circuit may be prevented from occurring during the process of connecting electrical connection components such as a bus bar to the upper surface of the battery case (171) and/or the rivet terminal (172). Although not shown in the drawing, the gasket exposure part (173a) may have an extended form to cover not only the outer surface of the terminal exposure part (172a) but also a portion of the upper surface.

In the case where the second gasket (173) is formed using a polymer resin, the second gasket (173) may be joined to the battery case (171) and the rivet terminal (172) by heat fusion. In this case, the sealing at the joining interface between the second gasket (173) and the rivet terminal (172) and the joining interface between the second gasket (173) and the battery case (171) may be strengthened. Meanwhile, in the case where the gasket exposure part (173a) of the second gasket (173) has a form that extends to the upper surface of the terminal exposure part (172a), the rivet terminal (172) may be joined integrally with the second gasket (173) by insert injection.

The remaining area (175) of the upper surface of the battery case (171), excluding the area occupied by the rivet terminal (172) and the second gasket (173), corresponds to a negative electrode terminal having the opposite polarity to the rivet terminal (172).

The second current collector plate (176) is coupled to the lower portion of the electrode assembly (141). The second current collector plate (176) is formed using a conductive metal material such as aluminum, steel, copper, and nickel, and is electrically connected to the non-coated part (146b) of the negative electrode.

Preferably, the second current collector plate (176) is electrically connected to the battery case (171). To this end, at least a portion of the edge portion of the second current collector plate (176) may be interposed and fixed between the inner surface of the battery case (171) and the first gasket (178b). In an embodiment, at least a portion of the edge portion of the second current collector plate (176) may be supported by the lower surface of the bead part (180) formed at the lower end of the battery case (171) and fixed to the bead part (180) by welding. In a modification embodiment, at least a portion of the edge portion of the second current collector plate (176) may be directly welded to the inner wall surface of the battery case (171).

The second current collector plate (176) may have a plurality of protrusions (not shown) formed radially on a surface facing the non-coated part (146b). If the protrusions are formed, the second current collector plate (176) may be pressed to press the protrusions into the non-coated part (146b) .

Preferably, the ends of the second current collector plate (176) and the non-coated part (146b) may be joined by welding, for example, laser welding.

A sealant (178) sealing the lower open end of the battery case (171) includes a cap plate (178a) and a first gasket (178b). The first gasket (178b) electrically separates the cap plate (178a) and the battery case (171). A crimping part (181) secures the edge of the cap plate (178a) and the first gasket (178b) together. The cap plate (178a) is provided with a vent part (179). The configuration of the vent part

(179) is substantially the same as in the above-described embodiment.

Preferably, the cap plate (178a) is formed using a conductive metal material. However, since the first gasket (178b) is interposed between the cap plate (178a) and the battery case (171), the cap plate (178a) does not have electrical polarity. The sealant (178) seals the open end of the lower portion of the battery case (171) and discharges gas when the internal pressure of a battery cell (170) increases above a critical value.

Preferably, the rivet terminal (172) electrically connected to the non-coated part (146a) of the positive electrode is used as the positive electrode terminal. In addition, the part (175) of the upper surface of the battery case (171) electrically connected to the non-coated part (146b) of the negative electrode through the second current collector plate (176), excluding the rivet terminal (172), is used as the negative electrode terminal. In this way, if the two electrode terminals are positioned on the upper portion of the lithium secondary battery, it is possible to place electrical connection components such as bus bars on only one side of the lithium secondary battery (170). This may lead to simplification of the battery pack structure and improvement of energy density. In addition, since the part (175) used as the negative electrode terminal has a substantially flat shape, a sufficient bonding area may be secured when bonding electrical connection components such as bus bars. Accordingly, the lithium secondary battery (170) may lower the resistance at the joint portion of the electrical connection component to a desirable level.

If the lithium secondary battery is formed with the above structure, current concentration is less than that of the conventional battery having an electrode tab, so the heat generation inside the battery may be effectively reduced, and thus the effect of improving the thermal safety of the battery may be obtained.

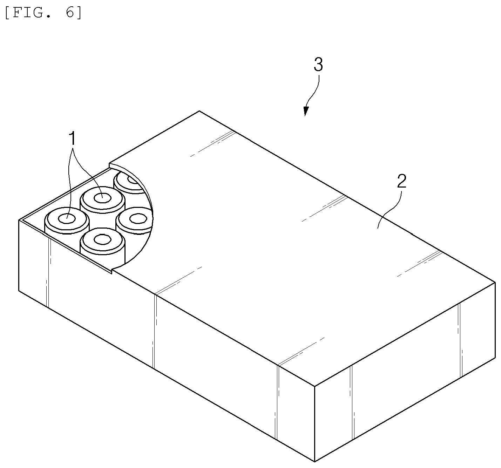

The lithium secondary battery of the present invention as described above may be used as a unit cell in manufacturing a battery pack. FIG. 6 schematically illustrates the configuration of a battery pack according to an embodiment of the present invention. Referring to FIG. 6, a battery pack (3) according to an embodiment of the present invention includes an assembly of electrically connected lithium secondary batteries (1) and a pack housing (2) that accommodates the assembly. The lithium secondary battery (1) is the lithium secondary battery according to the embodiment described above. In the drawing, for the convenience of drawing, parts such as a bus bar, a cooling unit, and an external terminal for electrical connection of the lithium secondary batteries (1) are omitted.

The battery pack (3) may be mounted on a vehicle. The vehicle may be, for example, an electric vehicle, a hybrid vehicle, or a plug-in hybrid vehicle. The vehicle includes a four-wheeled vehicle or a two-wheeled vehicle.

Hereinafter, the present invention will be described in more detail through specific examples.

**Preparation Example 1**

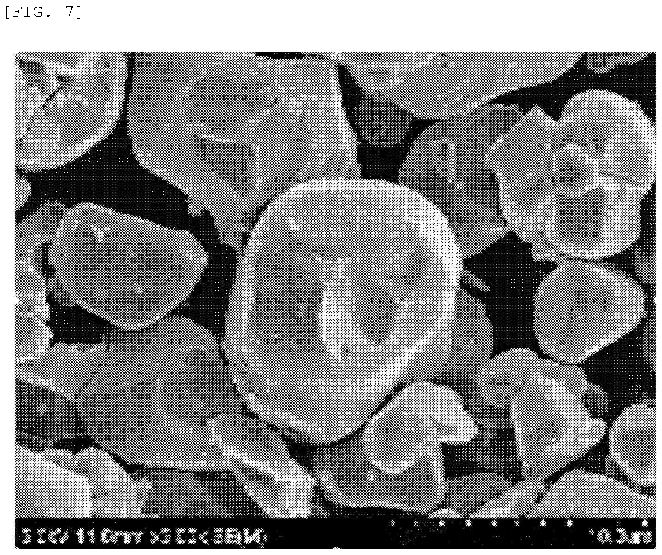

$MnSO_4$, $Al_2(SO_4)_3$, and $MgO$ were mixed in a weight ratio of 92.98:4.65:2.37, and then distilled water purged with $N_2$ was used to prepare $MnSO_4 \cdot 7H_2O$ containing $Al_2(SO_4)_3$ and $MgO$. The prepared $MnSO_4 \cdot 7H_2O$ was added into a continuous stirred tank reactor (CSTR, manufacturer: EMS Tech, product name: CSTR-L0) at a rate of 10 mL/h. As an alkalizing agent, a 40% sodium hydroxide aqueous solution was added through the sodium hydroxide aqueous solution supply part of the reactor at a rate of 10 mL/h, and a 25% ammonia solution was added through the ammonia solution supply part of the reactor at a rate of 30 mL/h, while maintaining the pH at 10.5 using a pH meter and a controller. The temperature of the reactor was set to 40°C, the residence time (RT) was adjusted to 10 hours, and the mixture was stirred at a speed of 1200 rpm to precipitate $Mn_3O_4$ containing Al. The obtained reaction solution was filtered through a filter, purified with distilled water, and dried to produce an Al-doped manganese precursor. The Al-doped manganese precursor produced as described above and a lithium raw material $Li_2CO_3$ were mixed in a molar ratio of 1.3:2, and then calcined at 900°C for 6 hours to obtain a lithium manganese-based oxide $Li_{1.3}Mn_{1.9}Al_{0.1}O_4$. FIG. 7 is a surface image at 3,000 times magnification of the lithium manganese-based oxide produced in Preparation Example 1, acquired by a scanning electron microscope, and it was confirmed that lithium manganese-based oxide particles produced as described above were particles in a single particle form.

The lithium manganese-based oxide and boric acid ($H_3BO_3$) as a coating raw material were mixed in an amount such that the content of B was 1,000 ppm. Afterwards, heat treatment was performed at 600°C for 8 hours to prepare a first positive electrode active material A with a coating layer formed thereon.

**Preparation Example 2**

A lithium manganese-based oxide $Li_{1.3}Mn_{1.9}Al_{0.1}O_4$ was obtained in the same manner as Preparation Example 1, except that the Al-doped manganese precursor and the lithium raw material $Li_2CO_3$ were calcined at 750°C for 6 hours. The prepared lithium manganese-based oxide was confirmed to have a secondary particle form.

The lithium manganese-based oxide and boric acid ($H_3BO_3$) as a coating raw material were mixed in an amount such that the B content was 1,200 ppm. Thereafter, heat treatment was performed at 600°C for 8 hours to prepare the first positive electrode active material B with a coating layer formed thereon.

**Preparation Example 3**

$NiSO_4$, $CoSO_4$, and $MnSO_4$ were mixed in distilled water in amounts such that the molar ratio of nickel: cobalt: manganese was 94:5:1 to prepare a transition metal aqueous solution with a concentration of 1.0 M.

Then, deionized water was added to the reactor, and nitrogen gas was purged into the reactor to remove dissolved oxygen in the water and form a non-oxidizing atmosphere inside the reactor. After that, 2.0 M NaOH was added to maintain the pH inside the reactor at 10.5.

Thereafter, the transition metal aqueous solution was added into the reactor at a rate of 10 mL/hr, and the NaOH aqueous solution and $NH_4OH$ aqueous solution were added at a rate of 10 mL/hr and 5 mL/hr, respectively, while conducting a co-precipitation reaction under the conditions of a reaction temperature of 60°C, pH 10, and a stirring speed of 1,000 rpm for 2 hours to prepare a precursor having an average particle diameter ($D_{50}$) of 4 $\mu$m and represented by $Ni_{0.93}Co_{0.05}Mn_{0.01}(OH)_2$.

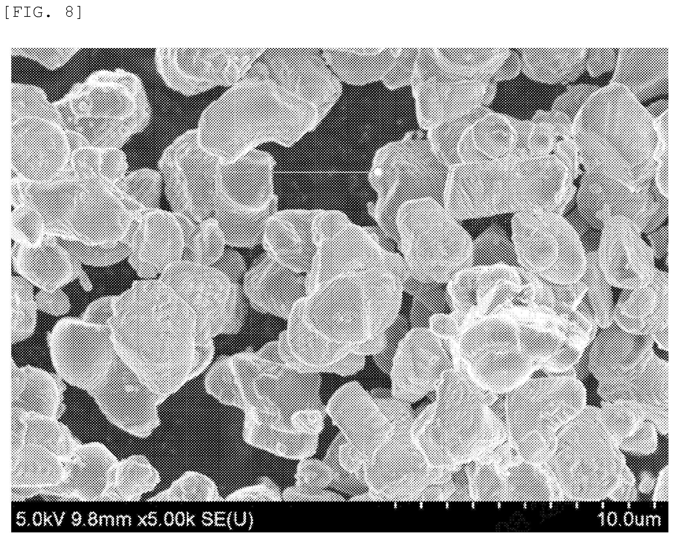

The precursor, LiOH, and a doping element Al were mixed so that the molar ratio of Ni:Co:Mn:Al was 93:5:1:1, and calcined at 600°C for 13 hours to prepare Li $[Ni_{0.93}Co_{0.05}Mn_{0.01}Al_{0.01}]O_2$. FIG. 8 is a surface image at 5,000 times magnification of the lithium nickel-based oxide prepared in Preparation Example 3, acquired by a scanning electron microscope, and it was confirmed that the lithium nickel-based oxide particles prepared were particles in a single particle form.

Then, the $Li[Ni_{0.93}Co_{0.05}Mn_{0.01}Al_{0.01}]O_2$ was washed with water, dried, and then $Co(OH)_2$ was mixed in an amount such that the Co content was 39,000 ppm, and $Al_2O_3$ was mixed in an amount such that the Al content was 500 ppm. Afterwards, a second positive electrode active material A coated with Co and Al was prepared by heat-treating at 500°C for 8 hours.

**Preparation Example 4**

$NiSO_4$, $CoSO_4$, and $MnSO_4$ were mixed in distilled water in amounts such that the molar ratio of nickel: cobalt: manganese was 90:6:4 to prepare a transition metal aqueous solution with a concentration of 1.0 M.

Then, deionized water was added to the reactor, and nitrogen gas was purged into the reactor to remove dissolved oxygen in the water and form a non-oxidizing atmosphere inside the reactor. Afterwards, 2.0 M NaOH was added to maintain the pH inside the reactor at 11.0.

Thereafter, the transition metal aqueous solution was injected into the reactor at a rate of 10 mL/hr, and the NaOH aqueous solution and the $NH_4OH$ aqueous solution were injected at a rate of 10 mL/hr and 5 mL/hr, respectively, while the co-precipitation reaction was performed under the conditions of a reaction temperature of 60°C, pH 11, and a stirring speed of 500 rpm for 4 hours to produce a precursor having an average particle diameter ($D_{50}$) of 9 $\mu$m and represented by $Ni_{0.9}Co_{0.06}Mn_{0.04}(OH)_2$.

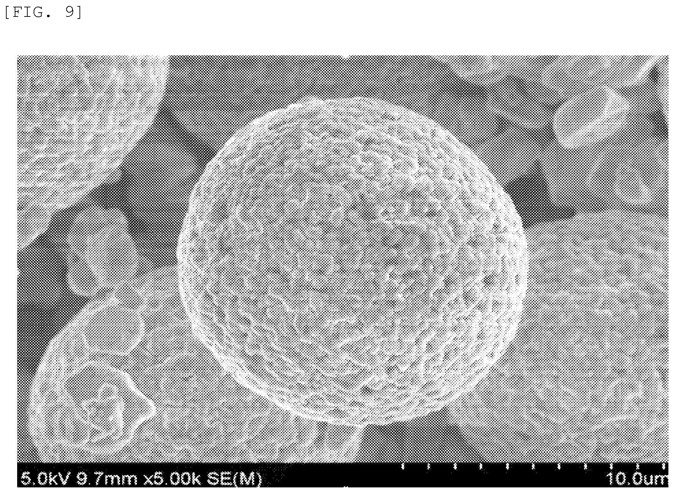

The precursor, LiOH, and a doping element Al were mixed so that the molar ratio of Ni:Co:Mn:Al was 90:6:3:1, and calcined at 800°C for 13 hours to produce $Li[Ni_{0.90}Co_{0.06}Mn_{0.03}Al_{0.01}]O_2$. FIG. 9 is a surface image at 5,000 times magnification of the lithium nickel-based oxide prepared in Preparation Example 4, acquired by a scanning electron microscope, and it was confirmed that the lithium nickel-based oxide particles prepared above were secondary particles.

Then, the $Li[Ni_{0.90}Co_{0.06}Mn_{0.03}Al_{0.01}]O_2$ was washed with water, dried, and then mixed with $Al_2O_3$ in an amount such that the Al content was 500 ppm. Thereafter, heat treatment was performed at 600°C for 8 hours to prepare an Al-coated second positive electrode active material B.

The first positive electrode active material and the second positive electrode active material prepared in Preparation Examples 1 to 4 have the characteristics shown in Table 1 below.

[Table 1]

|  | Composition | $D_{50}$ | Particle form |
|---|---|---|---|
| First positive electrode active material A | $Li_{1.3}Mn_{1.9}Al_{0.1}O_4$ | 12.7 $\mu$m | Single particle form |
| First positive electrode active material B | $Li_{1.3}Mn_{1.9}Al_{0.1}O_4$ | 12.6 $\mu$m | Secondary particle |
| Second positive electrode active material A | $Li[Ni_{0.93}Co_{0.05}Mn_{0.01}Al_{0.01}]O_2$ | 4.0 $\mu$m | Single particle form |
| Second positive electrode active material B | $Li[Ni_{0.90}Co_{0.06}Mn_{0.03}Al_{0.01}]O_2$ | 9 $\mu$m | Secondary particle |

**Example 1**

The first positive electrode active material A prepared in Preparation Example 1 and the second positive electrode active material A prepared in Preparation Example 3 were mixed in a weight ratio of 60:40 to prepare a positive electrode material, and the positive electrode material, carbon nanotubes as a conductive material, PVDF as a binder, and a hydrogenated nitrile butadiene copolymer as a dispersant were mixed in a weight ratio of 97.31:0.8:1.65:0.24 in an N-methylpyrrolidone solvent to prepare a positive electrode slurry. The positive electrode slurry was applied to one surface of an aluminum current collector having a thickness of 15 $\mu$m, dried at 130°C, and then rolled to manufacture a positive electrode.

A negative electrode slurry was prepared by mixing natural graphite as a negative electrode active material, SBR as a binder, and CMC as a dispersant in distilled water in a weight ratio of 98.1:1.0:0.9. The negative electrode slurry was applied to a copper current collector with a thickness of 10 $\mu$m, dried at 80°C, and rolled to manufacture a negative electrode.

A polyethylene separator with a 3 $\mu$m CCS coating on both sides was interposed between the positive and negative electrodes manufactured as described above, and the separator/positive electrode/separator/negative electrode were laminated in that order, and then wound to manufacture an electrode assembly. The electrode assembly manufactured as described above was inserted into a cylindrical battery can, and then an electrolyte was injected and sealed to manufacture a cylindrical lithium secondary battery.

In this case, the electrolyte was prepared by adding $LiPF_6$ at a concentration of 1.3 M to a mixed solvent of EC:DMC:EMC in a ratio of 20:75:5.

## Comparative Example 1

A cylindrical lithium secondary battery was manufactured in the same manner as in Example 1, except that the second positive electrode active material B prepared in Preparation Example 4 was used instead of the second positive electrode active material A.

## Comparative Example 2

A cylindrical lithium secondary battery was manufactured in the same manner as in Example 1, except that the first positive electrode active material B prepared in Preparation Example 2 was used instead of the first positive electrode active material A.

## Comparative Example 3

A cylindrical lithium secondary battery was manufactured in the same manner as in Example 1, except that the first positive electrode active material B prepared in Preparation Example 2 was used instead of the first positive electrode active material A, and the second positive electrode active material B prepared in Preparation Example 4 was used instead of the second positive electrode active material A.

## Experimental Example 1: Evaluation of High-Temperature Manganese Elution Amount

Using the cylindrical lithium secondary batteries manufactured in Example 1 and Comparative Examples 1 to 3, the manganese elution amount after activation and the manganese elution amount after storage at a high temperature were measured.

(1) Evaluation of Manganese Elution Amount after Activation

The cylindrical lithium secondary batteries of Example 1 and Comparative Examples 1 to 3 were charged to 4.2 V and 0.1 C at a constant current of 0.2 C at 25°C, respectively, and then activated by discharging to 2.5 V at a constant current of 0.2 C, and then fully discharged to 2.5 V. The cylindrical lithium secondary batteries were disassembled, 1 g of each negative electrode was collected, and the content of manganese elution on the surface of the negative electrode was measured using ICP analysis. The results are shown in Table 2 below.

(2) Evaluation of Manganese Elution Amount after Storage at High Temperature

The cylindrical lithium secondary batteries manufactured in Example 1 and Comparative Examples 1 to 3 were charged to 4.2 V and 0.1 C at a constant current of 0.2 C at 25°C, respectively, and then activated by discharging to 2.5 V at a constant current of 0.2 C. After that, the cylindrical lithium secondary batteries were charged to 4.2 V, 0.1 C at a constant current of 0.5 C at 25°C, stored at 55°C for 2 weeks, and then reversed to 2.5 V. The cylindrical lithium secondary batteries were disassembled, 1 g of each negative electrode was collected, and the Mn content eluted on the surface of the negative electrode was measured through ICP analysis. The results are shown in Table 2 below.

[Table 2]

| | Manganese elution amount after activation [ppm] | Manganese elution amount after storage at 55°C [ppm] |
|---|---|---|
| Example 1 | 11 | 65 |
| Comparative Example 1 | 39 | 165 |
| Comparative Example 2 | 40 | 170 |
| Comparative Example 3 | 55 | 201 |

Referring to Table 2 above, it can be confirmed that the battery manufactured in Example 1 has an absolutely smaller manganese elution amount after activation and after storage at a high temperature than the batteries manufactured in Comparative Examples 1 to 3. Through this, it can be understood that the battery manufactured in Example 1 has excellent high-temperature life characteristics.

**Experimental Example 2: Evaluation of Initial Battery Characteristics**

(1) Evaluation of Initial Discharge Capacity

The initial discharge capacity of the cylindrical lithium secondary batteries manufactured in Example 1 and Comparative Examples 1 to 3 was measured.

Specifically, each cell was charged to 4.2 V, 0.1 C at a constant current of 0.25 C at 40°C, and discharged to 3.0 V at a constant current of 1/3 C to evaluate the initial discharge capacity. The measurement results are shown in Table 3 below, with the discharge capacity of the 4680 cell manufactured in Example 1 set as 100% and, using this as the reference value, the relative discharge capacities of the cylindrical lithium secondary batteries manufactured in Example 1 and Comparative Examples 1 to 3 were obtained.

(2) Evaluation of Initial Resistance

The initial resistance of the cylindrical lithium secondary batteries manufactured in Example 1 and Comparative Examples 1 to 3 was measured.

Specifically, each cell was charged to SOC 50% at a constant current of 0.5 C at 40°C, discharged for 10 seconds at a constant current of 0.5 C, and then the initial resistance (DCIR) was calculated through the voltage drop occurred at that time. The measurement results are shown in Table 3 below, with the initial resistance of the cylindrical lithium secondary battery manufactured in Example 1 set as 100% and, using this as the reference value, the relative initial resistances of the cylindrical lithium secondary batteries manufactured in Example 1 and Comparative Examples 1 to 3 were obtained.

[Table 3]

|  | Initial discharge capacity [%] | Initial resistance [%] |
|---|---|---|
| Example 1 | 100.0 | 100.0 |
| Comparative Example 1 | 95.0 | 101.8 |
| Comparative Example 2 | 94.9 | 101.8 |
| Comparative Example 3 | 93.7 | 102.3 |

Referring to Table 3 above, it can be confirmed that the battery manufactured in Example 1 has a higher initial discharge capacity and lower initial resistance than the batteries manufactured in Comparative Examples 1 to 3.

**Experimental Example 3: Evaluation of High-Temperature Life Characteristics**

The life characteristics of the cylindrical lithium secondary batteries manufactured in Example 1 and Comparative Examples 1 to 3 were measured at 40°C.

Specifically, each of the cylindrical lithium secondary batteries manufactured in Example 1 and Comparative Examples 1 to 3 was charged at 40°C at a constant current of 0.25 C up to 4.2 V with a 0.1 C cutoff. Then, the battery was discharged at a constant current of 1/3 C until the battery reached 3.0 V.

The charge and discharge behavior was considered as 1 cycle, and the cycle was repeated 400 times. After 400 cycles, the high-temperature life characteristics were evaluated by measuring the capacity retention rate. The measurement results are shown in Table 4 below.

In this case, the capacity retention rate was calculated by the equation below.

Capacity retention rate (%) = {(discharge capacity after 400 cycles/discharge capacity after 1 cycle)} X 100.

[Table 4]

|  | Capacity retention rate (%) |
|---|---|
| Example 1 | 78.0 |
| Comparative Example 1 | 70.5 |
| Comparative Example 2 | 70.1 |
| Comparative Example 3 | 65.8 |

Referring to Table 4 above, it can be confirmed that the battery manufactured in Example 1 has a higher capacity retention rate when repeating charging and discharging at high temperatures than the batteries manufactured in Comparative Examples 1 to 3. Through this, it can be understood that the battery manufactured in Example 1 has excellent high-temperature life characteristics.

**Experimental Example 4: Evaluation of High-Temperature Storage Characteristics**

The cylindrical lithium secondary batteries manufactured in Example 1 and Comparative Examples 1 to 3 were charged to 4.2 V, 0.05 C under CC/CV, 0.5 C conditions at 25°C and discharged to 3.0 V under CC, 0.5 C conditions to perform initial charging and discharging, and then charged to 4.2 V, 0.05 C under CC/CV, 0.5 C conditions at 55°C and then stored at 55°C for 16 weeks.

(1) Capacity retention rate

After 16 weeks of storage, the lithium secondary battery was charged to 4.2 V, 0.05 C under CC/CV, 0.5 C conditions at 25°C, and discharged to 3.0 V under CC, 0.5 C to measure the capacity at discharge. The capacity retention rate was evaluated according to the equation below, and the results are shown in Table 5 below.

Capacity retention rate (%) = (discharge capacity after 16 weeks of storage/initial discharge capacity) X 100

(2) Resistance Increase Rate

After the initial charging and discharging, after checking the capacity at room temperature, the battery was charged to SOC 50% based on the discharge capacity, and discharged for 10 seconds at 0.5 C current, and the resistance was measured based on the voltage drop difference at that time, which was used as the initial resistance. After 16 weeks of storage at 55°C, the resistance was measured using the same method, which was used as the final resistance, and the resistance increase rate was calculated using the equation below. The results are shown in Table 5 below.

Resistance Increase Rate (%) = (Final Resistance - Initial Resistance)/(Initial Resistance) X 100.

[Table 5]

|  | Capacity retention rate (%) | Resistance increase rate (%) |
|---|---|---|
| Example 1 | 79.7 | 66.8 |
| Comparative Example 1 | 60.0 | 128.8 |
| Comparative Example 2 | 59.8 | 130.5 |
| Comparative Example 3 | 55.4 | 136.4 |

Referring to Table 5 above, it can be confirmed that the battery manufactured in Example 1 has a higher capacity retention rate and a lower resistance increase rate when stored at high temperatures than the batteries manufactured in Comparative Examples 1 to 3. Through this, it can be understood that the battery manufactured in Example 1 has excellent high-temperature storage characteristics.

[Description of Symbols]

1: Lithium secondary battery
2: Pack housing
3: Battery pack
10: Positive electrode
11: Negative electrode
12: Separator
20: Current collector
21: Active material layer
21a: Negative electrode active material layer
22: Non-coated part
22a: Non-coated part of negative electrode
22c: Non-coated part of positive electrode
24: Insulating layer
C: Winding center
140: Lithium secondary battery
141: Electrode assembly
142: Battery case
143: Sealant
143a: Cap plate
143b: First gasket
143c: Connection plate
143d: Protrusion part
144: First current collector plate
145: Second current collector plate
146: Insulator
146a: Positive electrode non-coated part
146b: Negative electrode non-coated part
147: Beading part
148: Crimping part
149: Lead
151: Lead hole
152: Venting part
170: Lithium secondary battery
171: Battery case
172: Rivet terminal
172a: Terminal exposure part
172b: Terminal insertion part
173: Second gasket
173a: Gasket exposure part
173b: Gasket insertion part
174: Insulation cap
176: Second current collector plate
178: Sealant
178a: Cap plate
178b: First gasket
179: Venting part
180: Beading part
181: Crimping part

**Claims**

1. A positive electrode material comprising: a first positive electrode active material comprising a lithium manganese-based oxide having a spinel structure; and a second positive electrode active material comprising a lithium nickel-based oxide having a layered structure and comprising nickel (Ni), cobalt (Co), manganese (Mn), and aluminum (Al), wherein the lithium manganese-based oxide and the lithium nickel-based oxide are particles in a single particle form.

2. The positive electrode material according to claim 1, wherein the lithium nickel-based oxide comprises nickel in 90 mol% or more among all metals excluding lithium.

3. The positive electrode material according to claim 1, wherein a weight ratio of the first positive electrode active material and the second positive electrode active material is 75:25 to 50:50.

4. The positive electrode material according to claim 1, wherein a ratio of an average particle diameter ($D_{50}$) of the first positive electrode active material and the second positive electrode active material is 5:1 to 1.5:1.

5. The positive electrode material according to claim 1, wherein an average particle diameter ($D_{50}$) of the first positive electrode active material is 5 $\mu$m to 20 $\mu$m.

6. The positive electrode material according to claim 1, wherein an average particle diameter ($D_{50}$) of the second positive electrode active material is 1 $\mu$m to 10 $\mu$m.

7. The positive electrode material according to claim 1, wherein the lithium manganese-based oxide has a composition represented by the following [Formula 1]:

[Formula 1] $\quad\quad Li_{1+a1}Mn_{2-x1}M^1_{x1}O_{4-y1}A_{y1}$

in Formula 1,

$M^1$ is one or more doping elements selected from the group consisting of Al, Li, Mg, Zn, B, W, Ni, Co, Fe, Cr, V, Ru, Cu, Cd, Ag, Y, Sc, Ga, In, As, Sb, Pt, Au, and Si,
A is one or more elements selected from the group consisting of F, Cl, Br, I, At, and S,
$0 \leq a1 \leq 0.4$, $0 < x1 \leq 0.5$, and $0 \leq y1 \leq 0.1$.

8. The positive electrode material according to claim 1, wherein the lithium manganese-based oxide comprises $M^1$ in 0.5 wt% to 3 wt% based on the total weight of the lithium manganese-based oxide.

9. The positive electrode material according to claim 1, wherein a first coating layer positioned on the surface of the lithium manganese-based oxide is comprised, and
the first coating layer comprises one or more elements selected from the group consisting of Al, Ti, W, F, P, Mg, Ni, Co, Fe, Cr, V, Cu, Ca, Zn, Zr, Nb, Mo, Sr, Sb, Bi, Si, S and B.

10. The positive electrode material according to claim 9, wherein the first coating layer is comprised in 0.05 wt% to 0.3 wt% based on the total weight of the first positive electrode active material.

11. The positive electrode material according to claim 1, wherein the lithium nickel-based oxide has a composition represented by the following [Formula 2]:

[Formula 2] $\quad\quad Li_{a2}[Ni_{x2}Co_{y2}Mn_{z2}Al_{w2}M^2_{v2}]O_2$

in Formula 2,

$M^2$ is one or more doping elements selected from the group consisting of W, Cu, Fe, V, Cr, Ti, Zr, Zn, In, Ta, Y, La, Sr, Ga, Sc, Gd, Sm, Ca, Ce, Nb, Mg, B, and Mo,
$0.8 \leq a2 \leq 1.2$, $0.9 \leq x2 < 1$, $0 < y2 \leq 0.2$, $0 < z2 \leq 0.2$, $0 < w2 \leq 0.2$, and $0 \leq v2 \leq 0.1$.

12. The positive electrode material according to claim 1, wherein a second coating layer positioned on the surface of the lithium nickel-based oxide is comprised, and
the second coating layer comprises one or more elements selected from the group consisting of Ti, W, B, F, P, Mg, Ni, Fe, Cr, V, Cu, Ca, Zn, Zr, Nb, Mo, Sr, Sb, Bi, Si, S, Co and Al.

13. The positive electrode material according to claim 12, wherein the second coating layer is comprised in 0.01 wt% to 5 wt% based on the total weight of the second positive electrode active material.

14. A lithium secondary battery comprising: an electrode assembly comprising a positive electrode comprising the positive electrode material according to any one of claims 1 to 13, a negative electrode, and a separator interposed between the positive electrode and the negative electrode; an electrolyte; and a battery case accommodating the electrode assembly and the electrolyte.

15. The lithium secondary battery according to claim 14, wherein the battery case is a cylindrical battery case.

16. The lithium secondary battery according to claim 14, wherein the lithium secondary battery has a ratio (form factor ratio) of a diameter (T) to a height (H) of 0.4 or more.

17. The lithium secondary battery according to claim 14, wherein the lithium secondary battery comprises a non-coated part on which an active material layer is not formed on at least a portion of the positive electrode and the negative electrode, and the non-coated part of the positive electrode and the non-coated part of the negative electrode are defined as electrode tabs.

[FIG. 1]

direction of winding

11  10  12

Z
↑
└→X

[FIG. 2]

20  22  21

Z
↑
└→Y

[FIG. 3]

[FIG. 4]

[FIG. 5]

[FIG. 6]

[FIG. 7]

[FIG. 8]

5.0kV 9.8mm x5.00k SE(U)                    10.0um

[FIG. 9]

## INTERNATIONAL SEARCH REPORT

| International application No. |
|---|
| **PCT/KR2024/018157** |

| A. | CLASSIFICATION OF SUBJECT MATTER |
|---|---|

**H01M 4/505**(2010.01)i; **H01M 4/525**(2010.01)i; **H01M 4/36**(2006.01)i; **H01M 4/70**(2006.01)i; **H01M 10/04**(2006.01)i; **H01M 10/052**(2010.01)i; **C30B 29/22**(2006.01)i; **H01M 4/02**(2006.01)i

According to International Patent Classification (IPC) or to both national classification and IPC

| B. | FIELDS SEARCHED |
|---|---|

Minimum documentation searched (classification system followed by classification symbols)

H01M 4/505(2010.01); H01M 10/052(2010.01); H01M 10/0525(2010.01); H01M 4/131(2010.01); H01M 4/36(2006.01); H01M 4/525(2010.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 양극 활물질(cathode active material), 스피넬 구조(spinel structure), 리튬 망간계 산화물(lithium manganese oxide), 리튬 니켈계 산화물(lithium nickel oxide), 단입자(single particle)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | KR 10-2019-0051864 A (LG CHEM, LTD.) 15 May 2019 (2019-05-15) See paragraphs [0069] and [0118]; and claim 1. | 1-17 |
| A | KR 10-2023-0095271 A (POSCO HOLDINGS INC. et al.) 29 June 2023 (2023-06-29) See entire document. | 1-17 |
| A | WO 2023-225985 A1 (CONTEMPORARY AMPEREX TECHNOLOGY CO., LIMITED) 30 November 2023 (2023-11-30) See entire document. | 1-17 |
| A | KR 10-1275260 B1 (KOREA INSTITUTE OF CERAMIC ENGINEERING AND TECHNOLOGY et al.) 18 June 2013 (2013-06-18) See entire document. | 1-17 |
| A | KR 10-2339704 B1 (ECOPRO BM CO., LTD.) 15 December 2021 (2021-12-15) See entire document. | 1-17 |

☐ Further documents are listed in the continuation of Box C.  ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **21 February 2025** | **21 February 2025** |

| Name and mailing address of the ISA/KR | Authorized officer |
|---|---|
| **Korean Intellectual Property Office Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

# EP 4 769 562 A1

## INTERNATIONAL SEARCH REPORT
### Information on patent family members

| International application No. |
|---|
| **PCT/KR2024/018157** |

| Patent document cited in search report | | | Publication date (day/month/year) | Patent family member(s) | | | Publication date (day/month/year) |
|---|---|---|---|---|---|---|---|
| KR | 10-2019-0051864 | A | 15 May 2019 | CN | 110574194 | A | 13 December 2019 |
| | | | | CN | 110574194 | B | 03 June 2022 |
| | | | | CN | 110582875 | A | 17 December 2019 |
| | | | | CN | 110582875 | B | 21 April 2023 |
| | | | | CN | 111213264 | A | 29 May 2020 |
| | | | | CN | 111213264 | B | 24 June 2022 |
| | | | | EP | 3609002 | A2 | 12 February 2020 |
| | | | | EP | 3609002 | A4 | 05 August 2020 |
| | | | | EP | 3609003 | A1 | 12 February 2020 |
| | | | | EP | 3609003 | A4 | 22 April 2020 |
| | | | | EP | 3609003 | B1 | 12 June 2024 |
| | | | | EP | 3683873 | A2 | 22 July 2020 |
| | | | | EP | 3683873 | A4 | 05 August 2020 |
| | | | | EP | 3683873 | B1 | 12 April 2023 |
| | | | | JP | 2020-525990 | A | 27 August 2020 |
| | | | | JP | 2020-532842 | A | 12 November 2020 |
| | | | | JP | 2020-537324 | A | 17 December 2020 |
| | | | | JP | 7045549 | B2 | 01 April 2022 |
| | | | | JP | 7045586 | B2 | 01 April 2022 |
| | | | | JP | 7047217 | B2 | 05 April 2022 |
| | | | | KR | 10-2019-0051862 | A | 15 May 2019 |
| | | | | KR | 10-2019-0051863 | A | 15 May 2019 |
| | | | | KR | 10-2264736 | B1 | 15 June 2021 |
| | | | | KR | 10-2460353 | B1 | 31 October 2022 |
| | | | | KR | 10-2656222 | B1 | 11 April 2024 |
| | | | | US | 11258056 | B2 | 22 February 2022 |
| | | | | US | 11532807 | B2 | 20 December 2022 |
| | | | | US | 2020-0083524 | A1 | 12 March 2020 |
| | | | | US | 2020-0119341 | A1 | 16 April 2020 |
| | | | | US | 2020-0343536 | A1 | 29 October 2020 |
| | | | | WO | 2019-088805 | A2 | 09 May 2019 |
| | | | | WO | 2019-088805 | A3 | 20 June 2019 |
| | | | | WO | 2019-088806 | A1 | 09 May 2019 |
| | | | | WO | 2019-088807 | A2 | 09 May 2019 |
| | | | | WO | 2019-088807 | A3 | 20 June 2019 |
| KR | 10-2023-0095271 | A | 29 June 2023 | CN | 118435379 | A | 02 August 2024 |
| | | | | EP | 4456188 | A1 | 30 October 2024 |
| | | | | WO | 2023-121147 | A1 | 29 June 2023 |
| WO | 2023-225985 | A1 | 30 November 2023 | CN | 117916912 | A | 19 April 2024 |
| | | | | EP | 4303960 | A1 | 10 January 2024 |
| | | | | EP | 4303960 | A4 | 29 May 2024 |
| | | | | US | 2024-0387819 | A1 | 21 November 2024 |
| KR | 10-1275260 | B1 | 18 June 2013 | KR | 10-2012-0059018 | A | 08 June 2012 |
| KR | 10-2339704 | B1 | 15 December 2021 | CN | 113823774 | A | 21 December 2021 |
| | | | | EP | 3929160 | A1 | 29 December 2021 |
| | | | | JP | 2021-197360 | A | 27 December 2021 |
| | | | | US | 2021-0399297 | A1 | 23 December 2021 |

Form PCT/ISA/210 (patent family annex) (July 2022)

**EP 4 769 562 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230190076